# EUROPEAN PATENT APPLICATION

(11) **EP 2 713 387 A2**
(43) Date of publication of application: **02.04.2014**
(21) Application number: 13020106.4
(22) Date of filing: 24.09.2013
(51) Int. Cl.: H01L 21/36, H01L 21/02

(54) **ZnO based compound semiconductor device, and method for producing the same**

(30) Priority: 26.09.2012 JP 2012212956
(71) Applicant: Stanley Electric Co., Ltd., Meguro-ku Tokyo (JP)
(72) Inventor: Saito, Chizu, Tokyo (JP); Kato, Hiroyuki, Tokyo (JP); Sano, Michihiro, Tokyo (JP)
(74) Representative: Klang, Alexander H.

(57) **Abstract**

A method for producing a ZnO based semiconductor element comprises the steps of (a) forming an n-type ZnO based semiconductor layer, (b) forming a ZnO based semiconductor active layer above the n-type ZnO based semiconductor layer, (c) forming a first p-type ZnO based semiconductor layer above the ZnO based semiconductor active layer, and (d) forming a second p-type ZnO based semiconductor layer above the first p-type ZnO based semiconductor layer, wherein the step (d) comprises the steps of (d1) forming an n-type MgₓZn₁₋ₓO film having a Group 11 element supplied on its surface and doped with a Group 13 element, and (d2) annealing the n-type MgₓZn₁₋ₓO film for conversion into a p-type film doped with the 11 element, and the first p-type ZnO based semiconductor layer doped an element which reduces diffusion of the Group 11 element and the Group 13 element is formed in the step (c).

## Description

### BACKGROUND OF THE INVENTION

### A) FIELD OF THE INVENTI ON

This invention relates to a ZnO based compound semiconductor element, and a method for producing the same.

### B) DESCRIPTION OF THE RELATED ART

Zinc oxide (ZnO) is a direct transition-type semiconductor which has a band gap energy at room temperature of 3.37 eV, with a relatively high exciton binding energy of 60 meV. Use of zinc oxide has the advantage of reduced raw material cost as well as smaller influence on environment and human body. Accordingly, there is a high demand for a light-emitting device using ZnO having a high eficiency and low power consumption with reduced burden on environment.

However, the ZnO based compound semiconductor suffers from difficulty in realizing p-type electroconductivity due to self-compensation effect caused by the strong ionic property. For example, investigations have been conducted to develop a p-type ZnO based compound semiconductor having practical properties by using, for example, a Group 15 element such as N, P, As, or Sb, a Group 1 element such as Li, Na, or K, and a Group 11 element such as Cu, Ag, or Au as an acceptor impurity (see, for example, Japanese Patent Application Laid Open Nos. 2001-48698, 2001-68707, 2004-221132, and 2009-256142, and Japanese Patent No. 4365530).

Also disclosed are inventions wherein diffusion of n-type dopant in the ZnO based compound semiconductor element is prevented by using nitrogen (N) (see, for example, Japanese Patent Application Laid Open Nos. 2011-91077 and 2011-96902).

### SUMMARY OF THE INVENTION

An object of the present invention is to provide a ZnO based compound semiconductor element of high quality, and a method for producing the same.

According to an aspect of the present invention, there is provided a method for producing a ZnO based compound semiconductor element comprising the steps of (a) forming an n-type ZnO based compound semiconductor layer above a substrate, (b) forming a ZnO based compound semiconductor active layer above the n-type ZnO based compound semiconductor layer, (c) forming a first p-type ZnO based compound semiconductor layer above the ZnO based compound semiconductor active layer, and (d) forming a second p-type ZnO based compound semiconductor layer above the first p-type ZnO based compound semiconductor layer, wherein the step (d) comprises the steps of (d1) forming an n-type MgₓZn₁₋ₓO (0 ≤ x ≤ 0.6) single crystal film having a Group 11 element which is Cu and/or Ag supplied on its surface and doped with a Group 13 element which is at least one element selected from the group consisting of B, Ga, Al, and In, and (d2) annealing the n-type MgₓZn₁₋ₓO (0 ≤ x ≤ 0.6) single crystal film having the 11 element supplied on its surface for conversion into a p-type film doped with the 11 element, and the first p-type ZnO based compound semiconductor layer doped an element which reduces diffusion of the Group 11 element and the Group 13 element is formed in the step (c).

According to another aspect of the present invention, there is provided a ZnO based compound semiconductor element comprising an n-type ZnO based compound semiconductor layer, a ZnO based compound semiconductor active layer formed above the n-type ZnO based compound semiconductor layer,
a first p-type ZnO based compound semiconductor layer formed above the ZnO based compound semiconductor active layer, a second p-type ZnO based compound semiconductor layer formed above the first p-type ZnO based compound semiconductor layer, an n electrode electrically connected to the n-type ZnO based compound semiconductor layer, and a p electrode electrically connected to the second p-type ZnO based compound semiconductor layer, wherein the second p-type ZnO based compound semiconductor layer is a single crystal layer, (i) a Group 11 element which is Cu and/or Ag and (ii) at least one Group 13 element selected from the group consisting of B, Ga, Al, and In are co-doped in the second p-type ZnO based compound semiconductor layer, concentration of the Group 11 element is at least 1 x 10¹⁹ cm⁻³, and the concentration of the Group 11 element is approximately constant in thickness direction of the second p-type ZnO based compound semiconductor layer, and the first p-type ZnO based compound semiconductor layer is doped with an element which reduces the diffusion of the Group 11 element and the Group 13 element co-doped with the second p-type ZnO based compound semiconductor layer.

The present invention provides a ZnO based compound semiconductor element of high quality, and a method for producing the same.

### BRIEF DESCRIPTION OF THE DRAWINGS

FIG. 1 is a schematic cross sectional view of an MBE apparatus.

FIG. 2A is a schematic cross sectional view of the specimen before annealing. FIG. 2B is a time chart of shutter sequence of Zn cell, O cell, Ga cell, and Cu cell during formation of the alternate laminate structure. FIG. 2C is a schematic cross sectional view of an alternate laminate structure 54. FIG. 2D is a schematic cross sectional view of a Ga-doped ZnO single crystal layer 54a and a Cu layer 54b.

FIG. 3 shows graphs of CV properties and depth profile of impurity concentration of the alternate laminate structure of the specimens before the annealing.

FIG. 4 shows graphs of CV properties and depth profile of impurity concentration of the alternate laminate structure of the specimens after the annealing.

FIG. 5 shows graphs of depth profile of absolute concentration of Cu [Cu] and absolute concentration of Ga [Ga] after the annealing measured by SI MS.

FIGS. 6A and 6B are respectively graphs showing depth profile of concentration of Cu [Cu] and concentration of Ga [Ga] of Sample 2 measured by SIMS.

FIG. 7A is a schematic cross sectional view of the specimen before annealing of Sample 5. FIG. 7B shows graph of depth profile of concentration of Cu [Cu], concentration of Ga [Ga], and concentration of N [N] of Sample 5 measured by SIMS. FIG. 7C shows RHEED image of the alternate laminate structure from the [11-20] direction.

FIG. 8A is a schematic cross sectional view of the ZnO based compound semiconductor light emitting element of Example 1. FIG. 8B is a schematic cross sectional view of the alternate laminate structure 6A. FIG. 8C is a schematic cross sectional view of the ZnO based compound semiconductor light emitting element of modification of Example 1.

FIG. 9 is a time chart of an exemplary shutter sequence of the Zn cell, the Mg cell, the O cell, the Ga cell, and the Cu cell during formation of the alternate laminate structure.

FIG. 10A is a schematic cross sectional view of the ZnO based compound semiconductor light emitting element of Example 2. FIG. 10B is a schematic cross sectional view of another embodiment of active layer 15. FIG. 10C is a schematic cross sectional view of the alternate laminate structure 17A. FIG. 10D is a schematic cross sectional view of the ZnO based compound semiconductor light emitting element of modification of Example 2.

FIG. 11A is a schematic cross sectional view of the ZnO based compound semiconductor light emitting element of Example 3. FIG. 11B is a schematic cross sectional view of the ZnO based compound semiconductor light emitting element of modification of Example 3.

### DESCRIPTION OF EMBODIMENTS

First, the crystal formation apparatus used in the growth of ZnO based compound semiconductor layer and the like is described. In the Experiments, Examples, and Modifications, the method used for the crystal formation is molecular beam epitaxy (MBE). The ZnO based compound semiconductor contains at least Zn and O.

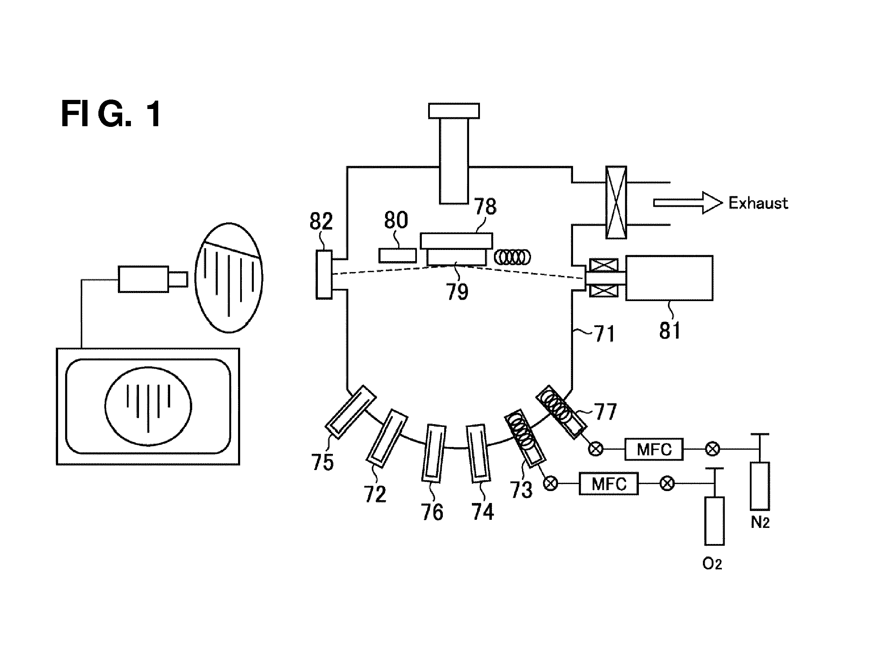

FIG. 1 is a schematic cross sectional view illustrating MBE apparatus. The apparatus has a vacuum chamber 71, and a Zn source gun 72, an O source gun 73, a Mg source gun 74, a Cu source gun 75, a Ga source gun 76,and an N source gun 77 are accommodated in the vacuum chamber 71.

The Zn source gun 72, the Mg source gun 74, the Cu source gun 75, and the Ga source gun 76 respectively include Knudsen cell for accommodating solid source of Zn(7N), Mg(6N), Cu(9N), and Ga(7N), and Zn beam, Mg beam, Cu beam, and Ga beam are ejected when the cell is heated.

The O source gun 73 and the N source gun 77 include an electrodeless discharge tube which uses a radio frequency wave of, for example, 13.56 MHz, and plasma is produced in the electrodeless discharge tube from the O₂ (6N) gas, the N₂ (6N) gas and the O radical beam, the N radical beam□is ejected relatively. The discharge tube may be the one prepared from alumina, high purity quartz, or PBN (pyrolytic boron nitride).

A substrate 79 is held by a stage 78 having a substrate heater. Each of the source guns 72 to 77 is provided with a cell shutter, the substrate 79 becomes irradiatable and non-irradiatable by the beam when the cell shutter is opened and closed. The substrate 79 is irradiated by the beam at the desired timing for the growth of the ZnO based compound semiconductor layer having the desired composition.

The band gap can be increased by adding Mg to the ZnO. However, phase separation occurs when Mg composition is too high since ZnO has wurtzite structure (hexagonal crystal) and MgO has rock salt structure (cubic crystal). In the MgₓZn₁₋ₓO where Mg composition in the MgZnO is x, x is preferably up to 0.6 to maintain the wurtzite structure. The representation MgₓZn₁₋ₓO includes ZnO with no addition of the Mg wherein x is 0.

n-type electroconductivity of the ZnO based compound semiconductor can be realized without doping any impurities. However, the n-type electroconductivity can be increased by doping impurities such as Ga. p-type electroconductivity of the ZnO based compound semiconductor can be realized by doping p-type impurities.

A thickness gauge 80 using a quartz oscillator is accommodated in the vacuum chamber 71, and flux intensity of each beam may be measured by film deposition rate measured by the thickness gauge 80.

The vacuum chamber 71 also has a gun 81 for reflection high energy electron diffraction (RHEED) and a screen 82 for RHEED image. The RHEED image helps evaluation of surface evenness and growth mode of the crystal layer formed on the substrate 79.

When the crystal growth is two dimensional epitaxial growth (single crystal growth) with flat surface, the RHEED image will exhibit a streak pattern, and when the crystal growth is three dimensional epitaxial growth (single crystal growth) with non-flat surface, the RHEED image will exhibit a spotted pattern. In the case of polycrystal growth, the RHEED image will exhibit a ring pattern.

Next, VI/II flux ratio in the MgₓZn₁₋ₓO(0 ≤ x ≤ 0.6) crystal growth is explained, and in the explanation, J_{Zn} represents the flux intensity of the Zn beam, J_{Mg} represents flux intensity of the Mg beam, and J_{O} represents the flux intensity of the O radical beam. The beams of Zn and Mg which are metal materials are respectively beams containing Zn or Mg atoms or clusters of several Zn or Mg atoms. Both atoms and clusters are effective for the crystal growth. The beam of O which is a gas material is a beam containing atom radical or neutral molecule, and the flux intensity of O considered herein is the flux intensity of the atom radical which is effective in the crystal growth.

k_{Zn} represents attachment coefficient of Zn which is probability of the Zn becoming attached to the crystal, k_{Mg} represents attachment coefficient of Mg which is probability of the Mg becoming attached to the crystal, and k_{O} represents attachment coefficient of O which is probability of the O becoming attached to the crystal. Product k_{Zn}J_{Zn} of the Zn attachment coefficient k_{Zn} and flux intensity J_{Zn} and product k_{O}J_{O} of the O attachment coefficient k_{O} and the flux intensity J_{O} respectively correspond to number of Zn atoms, Mg atoms, and O atoms which attaches to unit area of the substrate in unit time.

VI/II flux ratio is defined as the ratio of the k_{O}J_{O} to the sum of k_{Zn}J_{Zn} and k_{Mg}J_{Mg}, namely, k_{O}J_{O}/(k_{Zn}J_{Zn}+ k_{Mg}J_{Mg}). The condition wherein VI/II flux ratio is less than 1 is referred to as "Group II rich condition" (or simply "Zn rich condition" when Mg is not present), the condition wherein VI/II flux ratio is equal to 1 is referred to as "stoichiometric condition", and the condition wherein VI/II flux ratio is greater than 1 is referred to as "Group VI rich condition" (or "O rich condition").

For the crystal growth on Zn face (+ c face), attachment coefficient k_{Zn}, k_{Mg}, and k_{O} can be regarded 1 when surface temperature of the substrate is up to 850°C, and the VI/II flux ratio may be represented by J_{O}/(J_{Zn} + J_{Mg}).

VI/II flux ratio can be calculated, for example, in the case of ZnO growth, by measuring the Zn flux as a Zn deposition speed F_{Zn} (nm/s) at room temperature by the thickness gauge 80, and converting the F_{Zn} (nm/s) to the J_{Zn} (atoms/cm²s).

On the other hand, O radical flux may be calculated by irradiating the O radical beam at a constant condition (for example, at an RF power of 300 W and an O₂ flow rate of 2.0 sccm) while changing the Zn flux to allow the ZnO growth; experimentally determining dependency of the ZnO growth rate on the Zn flux; fitting the results by using approximate expression of the ZnO growth rate G_{ZnO}: G_{ZnO}= [(k_{Zn}J_{Zn})⁻¹ + (k_{O}J_{O})⁻¹]⁻¹ to thereby calculate O radical flux J_{O} under such condition; and calculating the VI/II flux ratio from the thus obtained Zn flux J_{Zn} and O radical flux J_{O}.

Next, the first experiment and the second experiment of the inventors of the present invention are described. The inventors of the present invention found that the Ga-doped ZnO single crystal layer having Cu supplied on the layer (the alternate laminate structure) is converted to a p-type film by annealing. The first experiment will be described for four samples, namely, Sample 1 to Sample 4, and in the following description, the specimen before the annealing is referred to as the pre-annealing specimen and the specimen after staring the annealing is referred to as the post-annealing specimen.

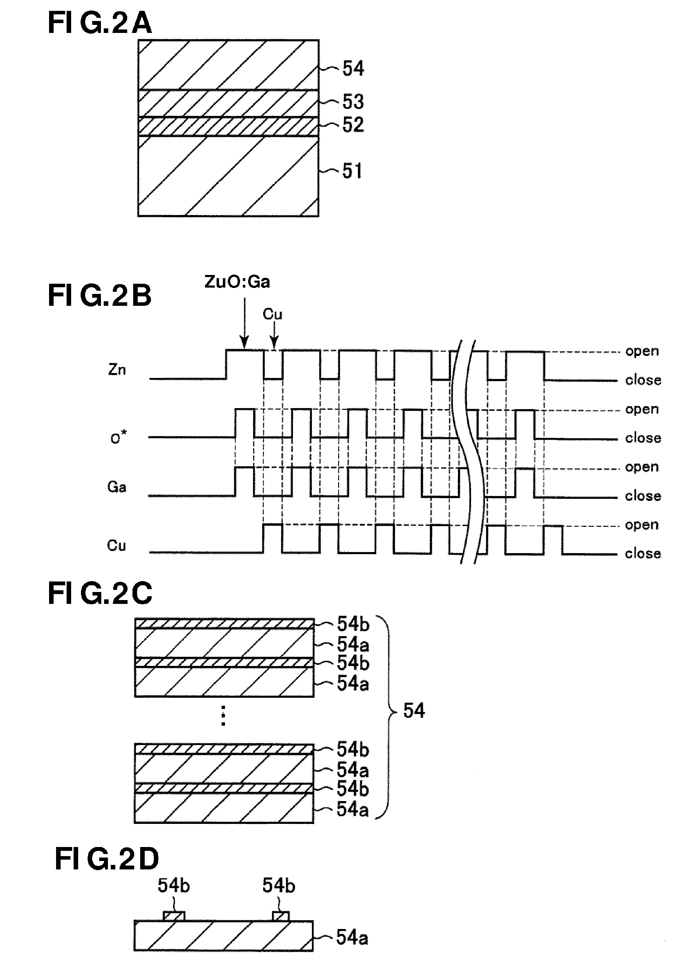

The method used for preparing the pre-annealing specimen of Sample 1 is described. FIG. 2A is a schematic cross sectional view of the pre-annealing speci men.

A Zn face ZnO (0001) substrate (hereinafter referred to as the ZnO substrate) 51 having n-type electroconductivity was thermally cleaned at 900°Cfor 30 minutes, and the temperature of the substrate 51 was reduced to 300°C. At this temperature (growth temperature, 300°C), a ZnO buffer layer 52 having a thickness of 30 nm was deposited on the ZnO substrate 51 by using the Zn flux F_{Zn} at 0.17 nm/s (J_{Zn} = 1.1 x 10¹⁵ atoms/ cm²s) and the O radical beam at an RF power of 300 W and an O₂ flow rate of 2.0 sccm (J_{O} = 8.1 x 10¹⁴ atoms/cm²s). Annealing was then conducted at 900°Cfor 10 minutes for improvement of crystallinity and surface evenness of the ZnO buffer layer 52.

On this ZnO buffer layer 52, an undoped ZnO layer 53 having a thickness 100 nm was deposited at a growth temperature of 900°C by using a Zn flux F_{Zn} of 0.17 nm/s (J_{Zn}= 1.1 x 10¹⁵ atoms/cm²s) and the O radical beam at an RF power of 300 W and an O₂ flow rate of 2.0 sccm (J_{O}=8.1 x 10¹⁴ atoms/cm²s). This undoped ZnO layer 53 was an n-type ZnO layer. Zn, O, and Ga were supplied at a timing different from Cu on the undoped ZnO layer 53 to form an alternate laminate structure 54. The alternate laminate structure 54 was formed at a temperature of 300°C.

FIG. 2B is a time chart showing shutter sequence of the Zn cell, the O cell, the Ga cell, and the Cu cell in forming the alternate laminate structure.

In forming the alternate laminate structure 54, the step of forming the Ga-doped ZnO single crystal layer by opening the Zn cell shutter, the O cell shutter, and the Ga cell shutter and closing the Cu cell shutter and the step of Cu attachment (the step of forming the Cu layer) by closing the Zn cell shutter, the O cell shutter, and the Ga cell shutter and opening the Cu cell shutter were alternately repeated. Since Ga is supplied during the formation of the ZnO single crystal layer, Ga is expected to be incorporated in the Zn site in the ZnO single crystal layer to function as a donor. Since the step of forming the Ga-doped ZnO single crystal layer and the step of attaching Cu on the Ga-doped ZnO single crystal layer are separately conducted with no overlap between the period when the O cell shutter is open and the period when the Cu cell shutter is open, the O radical and the Cu will not be simultaneously supplied.

In the step of forming the Ga-doped ZnO single crystal layer, the opening and closing the O cell shutter and the Ga cell shutter are simultaneously conducted, and the Zn cell shutter is opened before opening the O cell shutter and the Ga cell shutter and closed after closing the O cell shutter and the Ga cell shutter, and in other words, the open period of the Zn cell shutter include the open period of the O cell shutter and the Ga cell shutter. Since the O radical and the Cu are not simultaneously supplied and the surface of the Ga-doped ZnO single crystal layer is covered by Zn before and after the Cu attachment step (thereby inhibiting the exposure of the O), direct reaction between the O radical and the Cu is prevented. If the reaction between the active O radical and Cu takes place, formation of the good single crystal formation may be avoided. In addition, the binding of the Cu with the O is likely to take place while the Cu is in its divalent state when it is less likely to function as an acceptor.

In the preparation of the pre-annealing specimen of Sample 1, the open period of the O cell shutter and the Ga cell shutter was 16 seconds for each opening, and the open period of the Zn cell shutter was extended 1 second before and after the open period of the O cell shutter and the Ga cell shutter. The open period of the Zn cell shutter was 18 seconds for each opening, and the 16 second period when all of the Zn cell shutter, the O cell shutter, and the Ga cell shutter were open was the period allowed for each Ga-doped ZnO single crystal layer growth period. The open period of the Cu cell shutter was 10 seconds for each opening.

Each of the step of forming the Ga-doped ZnO single crystal layer and the Cu attachment step were alternately repeated for 140 times to deposit the alternate laminate structure 54 having a thickness of 480 nm. In the formation of the Ga-doped ZnO single crystal layer, the Zn flux F_{Zn} was 0.17 nm/s (J_{Zn} = 1.1 x 10¹⁵ atoms/cm²s), the O radical beam was irradiated at an RF power 300 W and an O₂ flow rate 2.0 sccm (J_{O}= 8.1 x 10¹⁴ atoms/cm²s), and the Ga cell temperature T_{Ga} was 490°C. VI/II flux ratio was 0.74 (Zn rich condition). In the Cu attachment step, the Cu cell temperature T_{Cu} was 930°C, and the Cu flux F_{Cu} was 0.0015 nm/s.

FIG. 2C is a schematic cross sectional view of the alternate laminate structure 54. The alternate laminate structure 54 has a structure wherein a Ga-doped ZnO single crystal layer 54a and a Cu layer 54b are alternately laminated one on another. This laminate structure may also be regarded as a laminate structure comprising 140 layers of the Ga-doped ZnO single crystal layers 54a each having the Cu supplied thereon disposed one on another in thickness direction.

The Ga-doped ZnO single crystal layer 54a has a thickness of approximately 3.3 nm, and the Cu layer 54b has a thickness (Cu attachment thickness) of up to 1 atomic layer, for example, about 1/20 atomic layer. In this case, Cu coverage of the surface of the Ga-doped ZnO single crystal layer 54a will be approximately 5%.

FIG. 2D is a schematic cross sectional view of the Ga-doped ZnO single crystal layer 54a and the Cu layer 54b. For example, the Cu layer 54b having a thickness of about 1/20 atomic layer is formed by Cu attached to a part of the surface of the Ga-doped ZnO single crystal layer 54a as shown in FIG. 2D. For the simplicity of the drawing, the alternate laminate structure is shown by the layer structure of FIG. 2C including such embodiment of Cu attachment.

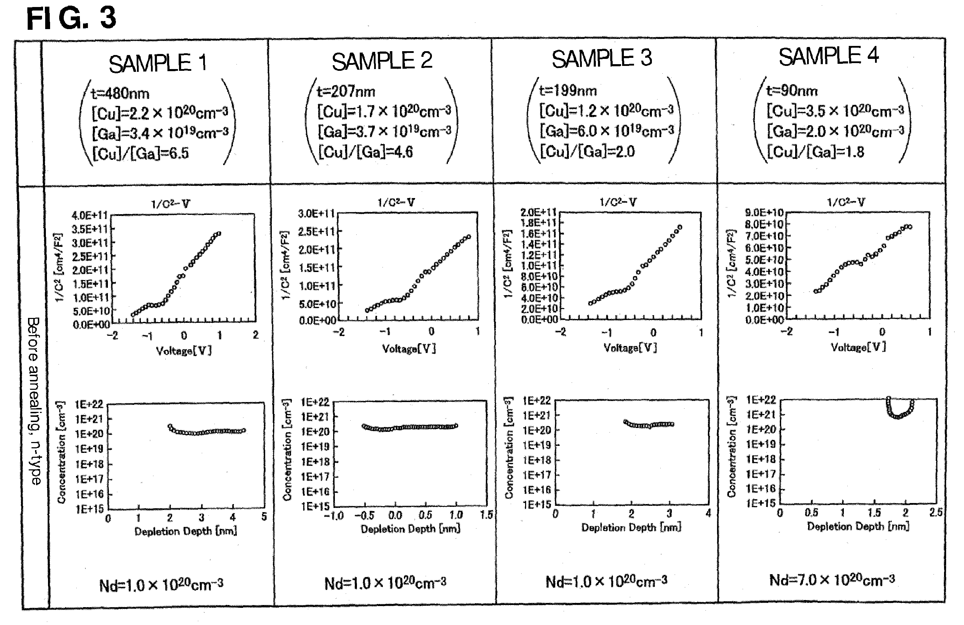

FIG. 3 shows graphs of CV profile and depth profile of the impurity concentration of the alternate laminate structure for the pre-annealing specimens. The upper graph is the one showing the CV profile and the lower graph is the one showing the depth profile. The measurement was conducted by ECV using the electrolyte for the Schottky electrode, and the graph shows the results analyzed by parallel model. The leftmost graphs are those for Sample 1, and in FIG. 3, graphs for Sample 1 to Sample 4 are shown from left to right including the samples that will be described below. In the graph showing the CV profile, the x axis represents voltage (unit, "V") and the y axis represents "1/C²" (unit, "cm⁴/F²"). Both axes are in linear scale. In the graph showing the depth profile, x axis represents position (unit "nm") in the depth (thickness) direction of the specimen. The y axis represents the impurity concentration (unit, "cm⁻³"). In this graph, the x axis is in linear scale and the y axis is in logarithmic scale.

With regard to the graph showing the CV profile of Sample 1, the curve rises upward to the right (namely, 1/C² increases with the increase in the voltage), and this means that the Ga-doped ZnO single crystal layer 54a with Cu supplied on the layer surface(the alternate laminate structure 54) has n-type electroconductivity. In other words, it is likely that the Cu localized on the Ga doped ZnO single crystal layers 54a is not functioning as an acceptor. It is to be noted that the inclination corresponds to the value of resistance.

With regard to the graph showing the depth profile of Sample 1, impurity concentration (donor concentration) N_{d} in the alternate laminate structure 54 of the pre-annealing specimen of Sample 1 is 1.0 x 10²⁰ cm⁻³.

Next, annealing of Sample 1 was conducted in the atmosphere at 650°C for 30 minutes. After this annealing, annealing at the same temperature but for 10 minutes was repeated four times.

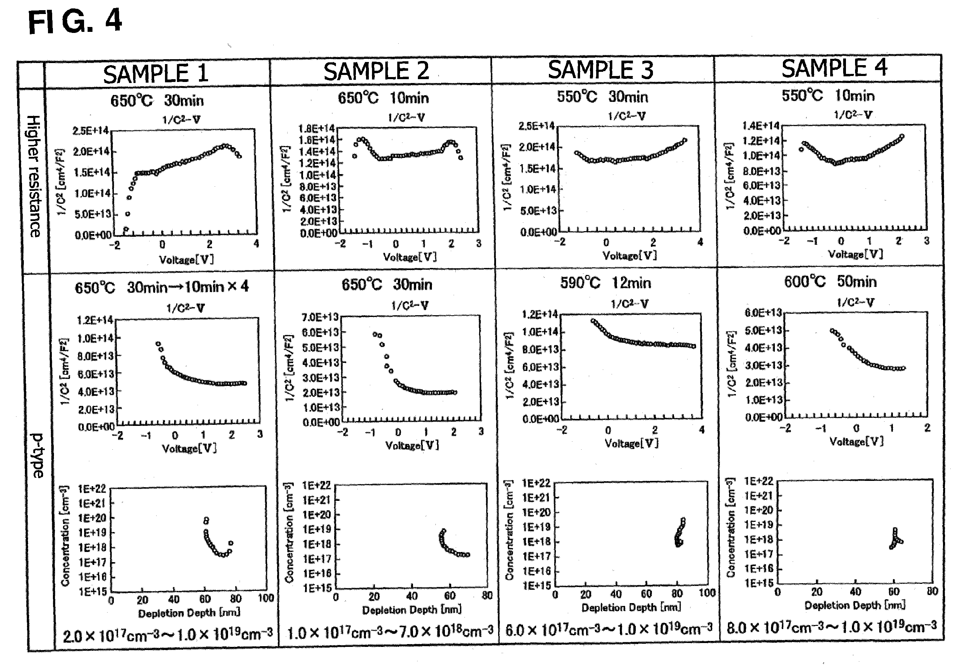

FIG. 4 shows graphs depicting CV profile and depth profile of the impurity concentration of the post-annealing specimens. The CV profile and the depth profile of the position where the alternate laminate structure 54 had been formed are shown in the graph. The leftmost graphs are those for Sample 1, and as in the case of FIG. 3, graphs for the post-annealing specimens of Sample 1 to Sample 4 are shown from left to right including the samples that will be described below.

With regard to the column of Sample 1, the graph in the upper row shows the CV profile after annealing at 650°Cfor 30 minutes, and the x and y axes are the same as the graph of the CV profile in FIG. 3. Compared with the pre-annealing specimen, resistance is higher at the position where the alternate laminate structure 54 (the Ga-doped ZnO single crystal layer 54a having Cu supplied on the layer surface) had been formed, and conceivably, this is due to the functioning of the Cu as a p-type impurity which reduces the functions of the Ga which is an n-type impurity.

In the lower part of the column, two graphs are shown which respectively depict the CV profile (upper graph) and the depth profile (lower graph) of the specimen which has been annealed once at 650°C for 30 minutes, and then four times at 650°C for 10 minutes, namely 70 minutes in total. The x and y axes of the graphs are the same as those in the graphs of FIG. 3.

In the upper graph showing the CV profile, the curve drops downward to the right (namely, 1/C² decreases with the increase in the voltage), and this means that the position where the alternate laminate structure 54 had been formed has p-type electroconductivity. Cu concentration per unit volume at the position where the alternate laminate structure 54 had been formed is higher than the Ga concentration, and this indicates that the dispersion of the Cu first results in the compensation of the Ga, and then, in the increase of the concentration of the p-type impurity. The lower graph showing the depth profile indicates that the impurity concentration (acceptor concentration) Nₐ of the position where the alternate laminate structure 54 had been formed of the post-annealing specimen of Sample 1 is 2.0 x 10¹⁷ cm⁻³ to 1.0 x 10¹⁹ cm⁻³.

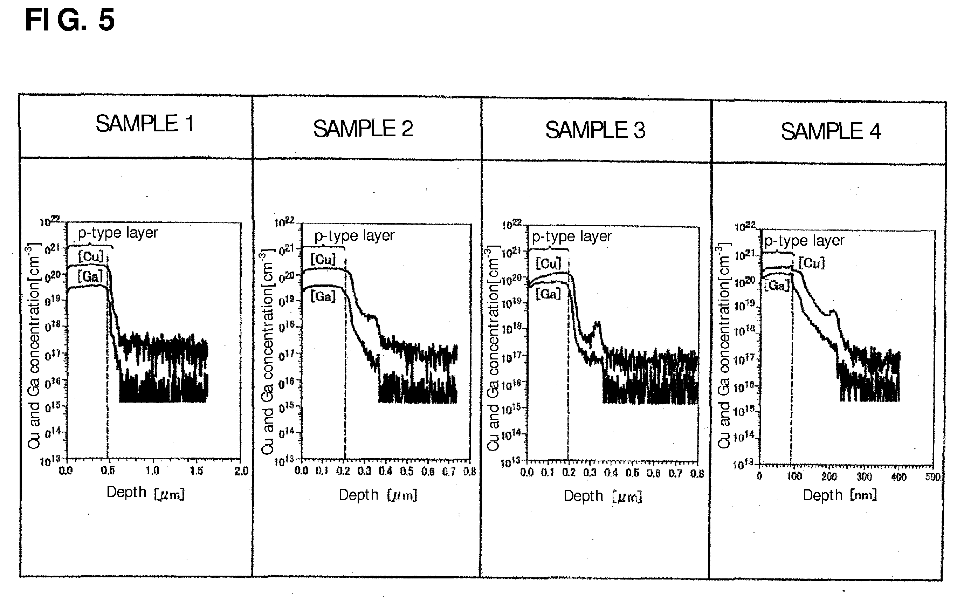

FIG. 5 shows graphs of depth profile of the absolute concentration of Cu [Cu] and the absolute concentration of Ga [Ga] after the annealing measured by secondary ion mass spectrometry (SIMS). The leftmost graphs are those for Sample 1, and in FIG. 5, graphs for post-annealing specimens of Sample 1 to Sample 4 are shown from left to right including the samples that will be described below. In the graph, the x axis represents position in the depth direction of the post-annealing specimen and the y axis represents the Cu concentration [Cu] and the Ga concentration [Ga]. The position in the depth direction of the post-annealing specimen is by the unit "µm" for Sample 1 to Sample 3, and "nm" for Sample 4. Unit of the [Cu] and [Ga] is "cm⁻³". In these graphs, the x axis is in linear scale and the y axis is in logarithmic scale.

With regard to the column of Sample 1, the range in the depth of 0.0 µm to 0.48 µm is the position wherein a p-type layer has been formed corresponding to the position where alternate laminate structure 54 had been formed. The Cu concentration [Cu] is 2.2 x 10²⁰ cm⁻³, and the Ga concentration [Ga] is 3.4 x 10¹⁹ cm⁻³, and as indicated in the graph, both are approximately constant through the thickness of the p-type layer. The term "approximately constant" used herein means that the concentration is within the range of 50% to 150% of the average concentration (2.2 x 10²⁰ cm⁻³ in the case of [Cu] of Sample 1). Cu is evenly distributed. [Cu] is higher than [Ga], and the ratio of [Cu] to [Ga] (namely, the value of [Cu]/[Ga]) is 6.5. It is to be noted that the [Cu] and [Ga] may not be accurately measured near the surface of the p-type layer, for example, due to the matters adsorbed on the surface. For example, a lower value is measured in the case of Sample 1.

Next, Sample 2 to Sample 4 are described. Samples 2 to 4 are samples prepared by adjusting the amount of Cu and Ga supplied during the production of the alternate laminate structure, and the value of [Cu]/[Ga] is different in each of Samples 2 to 4 from Sample 1.

The pre-annealing specimen of Samples 2 to 4 is similar to Sample 1 shown in FIG. 2A in that a ZnO buffer layer, an undoped ZnO layer, and an alternate laminate structure are disposed on the ZnO substrate 51 in this order. Samples 2 to 4, however, are different from Sample 1 in the conditions used for depositing the layers disposed on the ZnO substrate 51.

In the preparation of pre-annealing specimens of Samples 2 and 3, the ZnO buffer layer was deposited at a temperature of 300°C and growth period of 5 minutes. More specifically, the ZnO buffer layer having a thickness of 40 nm was deposited by using a Zn flux F_{Zn} of 0.16 nm/s, and irradiating the O radical beam at an RF power of 300 W and an O₂ flow rate of 2.0 sccm. Annealing was then conducted at 900°C for 15 minutes.

The undoped ZnO layer was deposited at a temperature of 900°C and growth period of 15 minutes. More specifically, the undoped ZnO layer having a thickness of 120 nm was deposited by using a Zn flux F_{Zn} of 0.16 nm/s, and irradiating the O radical beam at an RF power of 300 W and the O₂ flow rate of 2.0 sccm.

The alternate laminate structure was deposited at a temperature 300°C. The Ga-doped ZnO single crystal layer was deposited by using a Zn flux F_{Zn} of 0.16 nm/s, and irradiating the O radical beam at an RF power of 300 W and an O₂ flow rate of 2.0 sccm. The VI/II flux ratio was less than 1 corresponding to the Zn rich conditions. Ga cell temperature T_{Ga} was 498°C in the preparation of Sample 2, and 505°C in the preparation of Sample 3. Each growth period for Ga-doped ZnO single crystal layer was set at 16 seconds. The cell temperature in Cu attachment step T_{Cu} was 930°C, and the Cu flux F_{Cu} was 0.0015 nm/s. Each open period for the Cu cell shutter was 10 seconds. The step of depositing the Ga-doped ZnO single crystal layer and the Cu attachment step were alternately repeated 60 times to produce the alternate laminate structure. The growth period was 30 minutes. The alternate laminate structure had a thickness of 207 nm in Sample 2, and 199 nm in Sample 3. The pre-annealing specimens of Samples 2 and 3 were thereby prepared.

The method used for preparing the pre-annealing specimen of Sample 4 is different from those of Samples 2 and 3 in the conditions used in the deposition of the alternate laminate structure.

The alternate laminate structure of Sample 4 was formed at a temperature of 300°C. The Ga-doped ZnO single crystal layer was deposited by using a Zn flux F_{Zn} of 0.15 nm/s, and irradiating the O radical beam at an RF power of 300 W and an O₂ flow rate of 2.0 sccm. The VI/II flux ratio was less than 1 corresponding to the Zn rich conditions. Ga cell temperature T_{Ga} was 525°C. The growth period for Ga-doped ZnO single crystal layer was set at 16 seconds. The cell temperature in Cu attachment step T_{Cu} was 930°C, and the Cu flux F_{Cu} was 0.0015 nm/s. Each open period for the Cu cell shutter was 50 seconds. Each of the step of depositing the Ga-doped ZnO single crystal layer and the Cu attachment step were alternately repeated 30 times to produce the alternate laminate structure having a thickness of 90 nm. The pre-annealing specimen of Sample 4 was thereby prepared.

With regard to the columns of Samples 2 to 4 in FIG. 3, the upper graph showing the CV profile demonstrates that the alternate laminate structure experiences increase in the 1/C² with the increase in the voltage in Samples 2 to 4 as in the case of Sample 1. This in turn means that the alternate laminate structure (the Ga-doped ZnO single crystal layer having Cu supplied on the layer) of the pre-annealing specimen of Samples 2 to 4 has n-type electroconductivity.

The lower graphs showing the depth profile indicate that the donor concentration N_{d} of the alternate laminate structure in Samples 2, 3, and 4 are respectively 1.0 x 10²⁰ cm⁻³, 1.0 x 10²⁰cm⁻³, and 7.0 x 10²⁰ cm⁻³.

Samples 2 to 4 were subsequently subjected to annealing.

With regard to the column of Sample 2 in FIG. 4, Sample 2 was divided into 2 parts, and one was subjected to annealing in the atmosphere at 650°C for 10 minutes, and the other was subjected to annealing in the atmosphere at 650°C for 30 minutes. The graph in the upper row shows CV profile of Sample 2 which has been subjected to the annealing at 650°C for 10 minutes. At the position where the alternate laminate structure 54 (the Ga-doped ZnO single crystal layer having Cu supplied on the layer surface) had been formed, the resistance is higher compared to the pre-annealing resistance.

The graphs in the lower row respectively show the CV profile and the depth profile of the impurity concentration for Sample 2 which has been subjected to the annealing at 650°C for 30 minutes.

In the upper graph showing the CV profile, 1/C² decreases with the increase in the voltage, and this indicates that the position where the alternate laminate structure had been formed has changed to p-type. The lower graph showing the depth profile demonstrates that the acceptor concentration Nₐ at the position where the alternate laminate structure had been formed in Sample 2 which had been subjected to the annealing at 650°C for 30 minutes is 1.0 x 10¹⁷ cm⁻³ to 7.0 x 10¹⁸ cm⁻³.

The graph in the column of Sample 2 in FIG. 5 depicts depth profile of Cu concentration [Cu] and Ga concentration [Ga] of the specimen which has been annealed at 650°C for 30 minutes measured by SIMS. In the range corresponding to the position where the alternate laminate structure had been formed (the position where p-type layer has been formed), the Cu concentration [Cu] is 1.7 x 10²⁰ cm⁻³, the Ga concentration [Ga] id 3.7 x 10¹⁹ cm⁻³, and both are approximately constant through the thickness of the p-type layer. The [Cu]/[Ga] value is 4.6.

Sample 4 was also annealed in the atmosphere. The annealing was conducted 7 times at 550°C for 10 minutes, 4 times at 570°C for 10 minutes, 3 times at 580°C for 10 minutes, and once at 580°C for 5 minutes, and then 590°C for 12 minutes. The total annealing time was 157 minutes.

With regard to the column of Sample 3 in FIG. 4, the graph in the upper row is a graph showing CV profile after conducting the annealing 3 times at 550°C for 10 minutes (total annealing time, 30 minutes). Resistance of the position where the alternate laminate structure had been formed has increased compared with the resistance before the annealing.

The graphs in the lower row respectively show the CV profile and the depth profile of the impurity concentration for Sample 3 which has been subjected to the annealing at 590°C for 12 minutes (total annealing time, 157 minutes).

In the upper graph showing the CV profile, 1/C² decreases with the increase in the voltage, and this indicates that the position where the alternate laminate structure had been formed has changed to p-type. The lower graph showing the depth profile demonstrates that the acceptor concentration Nₐ at the position where the alternate laminate structure had been formed in the post-annealing specimen of Sample 3 is 6.0 x 10¹⁷ cm⁻³ to 1.0 x 10¹⁹ cm⁻³.

With regard to the column of Sample 3 in FIG. 5, the range corresponding to the position where the alternate laminate structure has been formed (the position where p-type layer has been formed) has a Cu concentration [Cu] of 1.2 x 10²⁰ cm⁻³ and a Ga concentration [Ga] of 6.0 x 10¹⁹ cm⁻³, and both are approximately constant through the thickness of the p-type layer. The value of [Cu]/[Ga] is 2.0.

Sample 4 was prepared by conducting the annealing in the atmosphere at 500°C for 10 minutes, at 525°C for 10 minutes, and at 550°C for 10 minutes, and then repeating the annealing 5 times at 600°C for 10 minutes. The total annealing time was 80 minutes.

With regard to the column of Sample 4 in FIG. 4, the graph in the upper row shows CV profile after the annealing at 550°C for 10 minutes. At the position where the alternate laminate structure had been formed, the resistance is higher compared to the pre-annealing resistance.

The graphs in the lower row respectively show the CV profile and the depth profile of the impurity concentration for the specimen after the annealing at 600°C for 50 minutes (the annealing of 10 minutes for 5 times) (80 minutes annealing in total).

In the upper graph showing the CV profile, 1/C² decreases with the increase in the voltage, and this indicates that the position where the alternate laminate structure had been formed has changed to p-type. The lower graph showing the depth profile demonstrates that the acceptor concentration Nₐ at the position where the alternate laminate structure had been formed in the post-annealing specimen of Sample 4 is 8.0 x 10¹⁷ cm⁻³ to 1.0 x 10¹⁹ cm⁻³.

With regard to the column of Sample 4 in FIG. 5, the Cu concentration [Cu] in the range corresponding to the position where the alternate laminate structure had been formed (the position where p-type layer has been formed) is 3.5 x 10²⁰ cm⁻³, and the Ga concentration [Ga] is 2.0 x 10²⁰ cm⁻³, and both are approximately constant in the thickness of the p-type layer. The [Cu]/[Ga] value is 1.8.

The first experiment demonstrates that the alternate laminate structure (Ga-doped ZnO single crystal layer) of Samples 1 to 4 is n-type in its as-grown state (see FIG. 3), and when annealed, it is converted to p-type (see lower column of FIG. 4) after experiencing increase in the resistance (see upper column of FIG. 4). As a result of the annealing, Cu in the Cu layer evenly diffuses in the interior of the Ga-doped ZnO single crystal layer, and conceivably, this Cu diffusion (generation of Cu⁺ functioning as an acceptor) results in the increase of the resistance (decrease of the donor concentration N_{d}) of the alternate laminate structure (Ga-doped ZnO single crystal layer), and hence, generation of the p-type ZnO single crystal layer co-doped with Cu ad Ga.

Comparison of Samples 1 to 4 indicates that conditions in the annealing required for conversion into the p-type (for example, temperature, time, and atmosphere) are likely to be different by the thickness of the alternate laminate structure and the Ga-doped ZnO single crystal layer, the Cu concentration [Cu], the Ga concentration [Ga], and the ratio of [Cu] to [Ga] ([Cu]/[Ga]) of the alternate laminate structure, and the like.

With regard to the value of [Cu]/[Ga] in Samples 1 to 3 wherein the Cu concentration [Cu] and the Ga concentration [Ga] are respectively within narrow ranges, the value of [Cu]/[Ga] is in the relation: Sample 1 > Sample 2 > Sample 3, and temperature or time of the annealing required for conversion to p-type decreases with the decrease in the [Cu]/[Ga] value. The value of [Cu]/[Ga] is, for example, preferably less than 100, and more preferably up to 50 in consideration of the risk of, for example, formation of donor-type point defect such as oxygen vacancy by high temperature annealing, decrease in the Cu concentration and the Ga concentration in the p-type layer associated with diffusion of Cu and Ga to the exterior of the p-type layer, loss of steepness at the p-n interface associated with the diffusion of the Cu and the Ga to the underlying layer (n-type layer), and deformation of the p-type region and the n-type region.

In addition, if it is conceived that Cu and Ga are compensated at Cu:Ga of 1:1 in the alternate laminate structure (the structure comprising the Ga-doped ZnO single crystal layer and the Cu supplied on the layer surface), conversion to p-type should be possible when [Cu]/[Ga] > 1. The p-type electroconductivity of practical level is more likely to be obtained, for example, when the [Cu]/[Ga] ≥ 2.

Accordingly, when the value of [Cu]/[Ga] at the position corresponding to the alternate laminate structure after the annealing is 1 < [Cu]/[Ga] < 100, the alternate laminate structure can be converted to the p-type by annealing at a relatively low temperature, and when the value is 2 ≤ [Cu]/[Ga] ≤ 50, the p-type electroconductivity of practical level may be realized by annealing at an even lower temperature.

In the first experiment, a p-type layer having a approximately constant Cu concentration [Cu] and a approximately constant Ga concentration [Ga] through the thickness was obtained as shown, for example, in FIG. 5. The Cu concentration [Cu] in the p-type layer was 1.2 x 10²⁰ cm⁻³ (in the case of Sample 3) to 3.5 x 10²⁰ cm⁻³ (in the case of Sample 4).

These results indicate that, Cu can be evenly doped in the thickness direction at least to a concentration of less than 1.0 x 10²¹ cm⁻³, in an order 10²⁰ cm⁻³ in the case of Sample 1 to Sample 4 so that the Cu will be at a concentration high enough, namely, at 1.0 x 10¹⁹ cm⁻³ or higher, for example, by the method of annealing the Ga-doped n-type ZnO single crystal layer having Cu supplied on the layer surface.

The inventors of the present invention has found after an intensive study that, in the ZnO based compound semiconductor layer, Cu impurity concentration (acceptor concentration) is about 2 orders of magnitude lower than Cu absolute concentration [Cu]. In consideration of this finding, a p-type layer having an acceptor concentration of at least 1.0 x 10¹⁷ cm⁻³ and less than at least 1.0 x 10¹⁹ cm⁻³ can be produced by the method of annealing the Ga-doped n-type ZnO single crystal layer having Cu supplied on the layer surface. In fact, the depth profile shown in the lower column of FIG. 4 demonstrate that the acceptor concentration Nₐ of Samples 1 to 4 is 1.0 x 10¹⁷ cm⁻³ (in the case of Sample 2) to 1.0 x 10¹⁹ cm⁻³ (in the case of Samples 1, 3, and 4).

A p-type layer can be deemed practical when the acceptor concentration is at least 1.0 x 10¹⁷ cm⁻³. Accordingly, the p-type layer obtained in the first experiment is a p-type ZnO based compound semiconductor single crystal layer having the p-type electroconductivity of practical level.

The method of annealing the Ga-doped ZnO single crystal layer having Cu supplied on the layer surface is capable of producing a Cu and Ga co-doped ZnO single crystal layer which has Cu evenly doped at a high concentration through the thickness of the layer and which has p-type electroconductivity of practical level. This method has also enabled the production by annealing at a low temperature.

The alternate laminate structure (Ga-doped ZnO single crystal layer having Cu supplied on the layer surface) exhibiting n-type electroconductivity is converted to p-type electroconductivity by annealing after increase in the resistance. For example, in the case of Sample 1, the specimen is converted to p-type, by conducing annealing at 650°C for 30 minutes to prepare a specimen exhibiting a high resistance (see graphs in the upper row of FIG. 4), namely, by conducing visualized step of increasing the resistance, and then conducting further annealing for 40 minutes to thereby accomplish the conversion to the p-type (see graphs in the lower row of FIG. 4). However, the alternate laminate structure is also converted to p-type when the pre-annealing specimen is subjected continuous annealing at 650°C for 70 minutes, and in this process, the alternate laminate structure may be deemed to have undergone latent increase in the resistance before the conversion to the p-type. Similarly, the alternate laminate structure could be converted to the p-type through latent increase in the resistance by annealing in the atmosphere, for example, by annealing the pre-annealing specimen of Sample 2 at 650°C for 30 minutes, the pre-annealing specimen of Sample 3 at 590°C for 12 minutes, or the pre-annealing specimen of Sample 4 at 600°C for 50 minutes. While Samples 3 and 4 are annealed at two or more different temperatures, the annealing may be conducted at the maximum temperature for a predetermined time.

However, it is also possible to consider that the alternate laminate structure is converted to the p-type not only through the latent or visualized increase in the resistance but also through the subsequent insulation, and the process of insulation may be made visualized by selecting an appropriate annealing condition. Accordingly, the conversion to the p-type of the alternate laminate structure may be described as a process through the latent or visualized increase in the resistance and the subsequent latent or visualized insulation process.

The inventors of the present invention found that the alternate laminate structure reconverted into p-type can again be imparted with n-type electroconductivity by further annealing. For example, when the pre-annealing specimen of Sample 2 was annealed in the atmosphere of 650°Cfor 120 minutes, the position where the alternate laminate structure had been formed was converted to the n-type. Accordingly, the annealing may be finished after the process of increasing the resistance and the conversion into p-type and before the returning to the n-type layer.

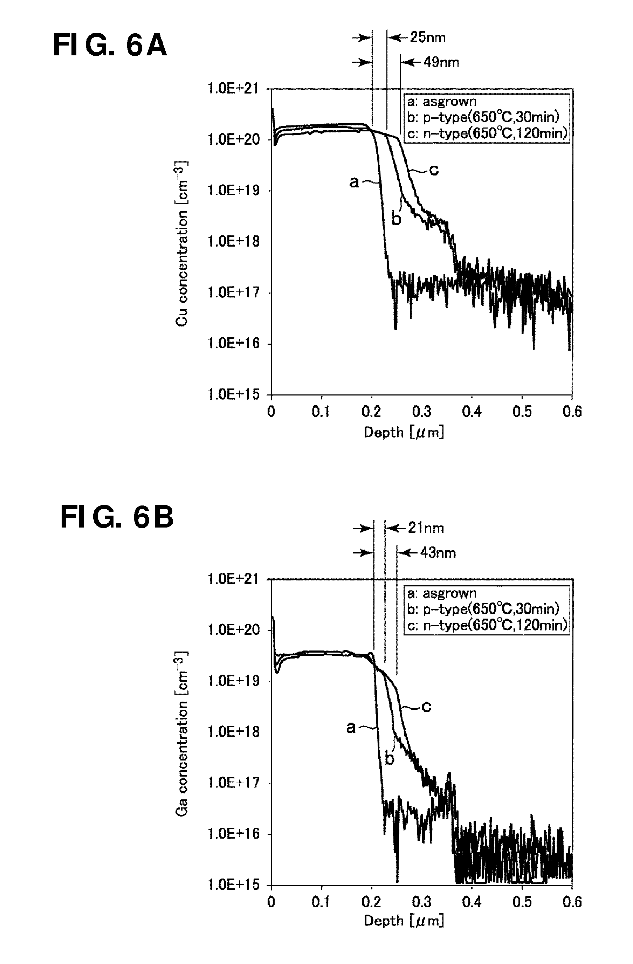

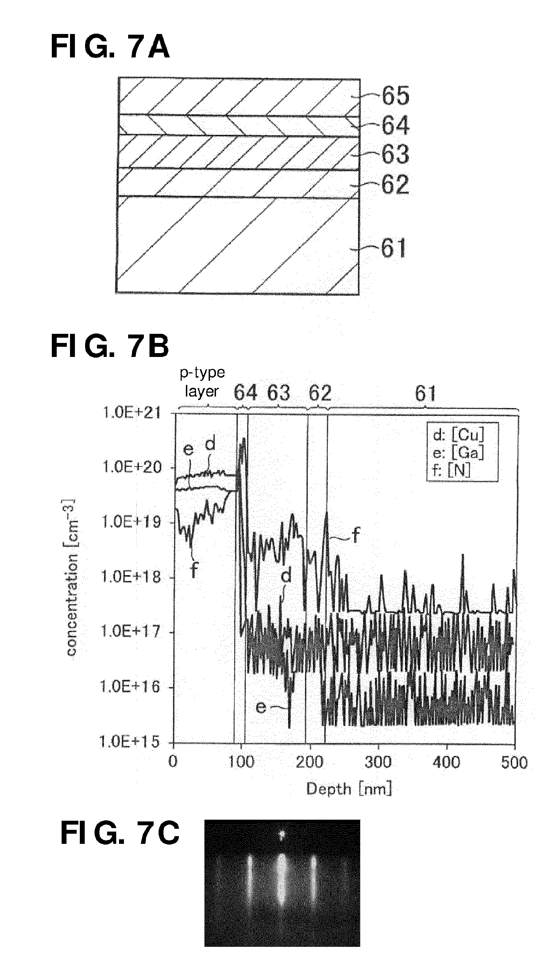

Next, the second experiment is described by referring to FIGS. 6 and 7. The inventors of the present invention found that, in the annealing of the alternate laminate structure (Ga doped ZnO single crystal layer having the Cu supplied on the layer), the Cu and the Ga diffuse to the areas other than the position where the alternate laminate structure had been formed based on the data shown in FIGS. 6A and 6B.

FIGS. 6A and 6B are graphs respectively showing depth profile of the Cu concentration [Cu] and the Ga concentration [Ga] of Sample 2 taken by SIMS. The x axis of the graph shows the position in depth direction of the specimen by the unit "µm", and the y axis shows the Cu concentration [Cu] and the Ga concentration [Ga] by the unit "cm⁻³". In these graphs, the x axis is in linear scale and the y axis is in logarithmic scale. Curve a is the Cu concentration [Cu] or the Ga concentration [Ga] of the specimen before the annealing, and curve b is the Cu concentration [Cu] or the Ga concentration [Ga] of the specimen which had been annealed at 650°Cfor 30 minutes to convert the alternate laminate structure into p-type. Curve c is the Cu concentration [on] or the Ga concentration [Ga] of the specimen which had been annealed at 650°Cfor 120 minutes for conversion to n-type of region which had once been converted to the p-type. The Cu concentration [Cu] and the Ga concentration [Ga] shown by the curve b are equal to those shown in the column of Sample 2 in FIG. 5.

With regard to FIG. 6A, comparison of the curve a with the curves b and c reveals that the Cu had diffused to the side of the underlying layer (the undoped ZnO layer) as a result of the annealing. When the depth at the start of the steep decline of the Cu concentration [Cu] in the concentration profile shown by the curve b and curve c is used as an index of the range where the Cu had diffused, the range of the Cu diffusion in the annealing at 650°C for 30 minutes (curve b) is the area of about 25 nm from the position where the alternate laminate structure had been formed to the side of the underlying layer. In the case of the annealing at 650°C for 120 minutes (curve c), the range of the Cu diffusion is the range of about 49 nm from the position where the alternate laminate structure had been formed to the side of the underlying layer. It is to be noted that, in the case of Cu, the Cu concentration [Cu] in the area of Cu diffusion is about the same level as the Cu concentration [Cu] in the position where the alternate laminate structure had been formed.

With regard to FIG. 6B, the comparison of the curve a with the curves b and c also reveals that the Ga had diffused to the side of the underlying layer as a result of the annealing. In the case of the Ga concentration [Ga], the concentration starts to steep decline after the gradual decline starting from near the edge of the position where the alternate laminate structure had been formed on the side of the underlying layer both in the cases of the curve b and the curve c. When the depth at the start of the steep decline of the Ga concentration [Ga] is used as an index of the range of the Ga diffusion, the range of the Ga diffusion in the annealing at 650°C for 30 minutes (curve b) is the area of about 21 nm from the position where the alternate laminate structure had been formed to the side of the underlying layer. In the case of the annealing at 650°C for 120 minutes (curve c), the range of the Ga diffusion is the range of about 43 nm from the position where the alternate laminate structure had been formed to the side of the underlying layer. It is to be noted that, in the case of the curve b, the Ga concentration [Ga] in the range of diffusion is slightly less than 40% or higher of the Ga concentration [Ga] in the position where the alternate laminate structure had been formed. In the curve c, the Ga concentration [Ga] in the area of diffusion is slightly less than 30% or higher of the Ga concentration [Ga] in the position where the alternate laminate structure had been formed.

As described above, the annealing results in the diffusion of the Cu and Ga into the exterior of the position where the alternate laminate structure had been formed. Cu is more likely to be diffused than Ga.

As demonstrated in FIGS. 6A and 6B, decline of the Cu concentration [Cu] and the Ga concentration [Ga] in the p-type layer (the position where the alternate laminate structure had been formed) associated with the exterior diffusion is very small in the conditions of the p-type conversion used in Sample 2 (the annealing in the atmosphere at 650°C for 30 minutes). In view of simply obtaining the p-type layer, the steepening of the change in the concentration at the p-n interface and the change in the morphology of the p-type region and the n-type region associated with the diffusion of the Cu and the Ga to the side of the underlying layer may not be regarded as particularly troublesome. However, from the point of the device using the pn interface, these may affect the properties of the device. In addition, as described above, the conditions of the annealing used for conversion to the p-type are believed to be different depending on the thickness of the alternate laminate structure and the Ga doped ZnO single crystal layer, the [Cu], the [Ga], and the [Cu]/[Ga] of the alternate laminate structure, and the like, and accordingly, there is some risk that the degree of the external diffusion of the Cu and the Ga increases to the problematic degree in some conditions.

In view of such situation, the inventors of the present invention prepared Sample 5 in order to prevent the diffusion of the Cu and Ga.

It is to be noted that the inventors of the present invention have already disclosed that the N (nitrogen)-doped n-type MgZnO layer has the function of suppressing the diffusion of the n-type dopant, for example, in Japanese Patent Application Laid Open No. 2011-91077.

FIG. 7A is a schematic cross sectional view of the pre-annealing specimen of Sample 5. In contrast to Sample 1 shown in FIG. 2A, a N (nitrogen)-doped p-type MgZnO layer 64 has been formed between the undoped ZnO layer and the alternate laminate structure.

A ZnO substrate 61 was thermally cleaned at 900°C for 30 minutes, and the temperature of the substrate 61 was reduced to 300°C. At this temperature and growth period of 4 minutes, a ZnO buffer layer 62 having a thickness of 30 nm was deposited on the ZnO substrate 61 by using the Zn flux F_{Zn} at 0.16 nm/s and the O radical beam at an RF power of 300 W and an O₂ flow rate of 2.0 sccm. Annealing was then conducted at 900°C for 30 minutes for improvement of crystallinity and surface evenness of the ZnO buffer layer 62.

On this ZnO buffer layer 62, an undoped ZnO layer 63 having a thickness 90 nm was deposited at a growth temperature of 900°C and growth period of 13 minutes by using a Zn flux F_{Zn} of 0.16 nm/s and the O radical beam at an RF power of 300 W and an O₂ flow rate of 2.0 sccm.

An N-doped p-type MgZnO layer 64 having a thickness of about 10 nm was deposited on the undoped ZnO layer 63 at the deposition temperature of 700°C, Zn flux F_{Zn} of 0.11 nm/s, Mg flux F_{Mg} of 0.0 4 nm/s, O radical beam irradiation conditions of the RF power of 300W and the O₂ flow rate of 2.0 sccm, N radical beam irradiation conditions of the RF power of 100W and the N₂ flow rate of 0.5 sccm. The growth time was 105 seconds, and the VI/II flux ratio was 1.22. The N₂ flow rate was adjusted to 0.5 sccm by setting the shutter of the N source gun at "off" (with the shutter closed).

Zn, O, and Ga were supplied at a timing different from Cu on the N-doped p-type MgZnO layer 64 to form an alternate laminate structure 65. The alternate laminate structure 65 was formed at a temperature of 300°C.

In the preparation of the alternate laminate structure 65 of Sample 5, the each growth period of the Ga doped ZnO single crystal layer was 16 seconds and each open period of the Cu cell shutter was 10 seconds. Each of the step of depositing the Ga-doped ZnO single crystal layer and each of the step of Cu attachment were alternately repeated for 30 times to obtain the alternate laminate structure 65 having a thickness about 90 nm. In the step of depositing the Ga-doped ZnO single crystal layer, the Zn flux F_{Zn} was 0.16 nm/s, and the O radical beam irradiation conditions included the RF power of 300 W, the O₂ flow rate of 2.0 sccm, and the Ga cell temperature T_{Ga} of 505°C. The VI/II flux ratio was smaller than 1, indicating the Zn rich conditions. In the step of Cu attachment, the Cu cell temperature T_{Cu} was 930°C, and the Cu flux F_{Cu} was 0.0015 nm/s.

The thus prepared specimen was annealed in the atmosphere at 610°C for 35 minutes to convert the alternate laminate structure 65 to a p-type structure.

FIG. 7B shows the depth profile of the Cu concentration [Cu], the Ga concentration [Ga], and the N concentration [N] of Sample 5 by SIMS. In the graph, the x axis represents position in the depth direction of the post-annealing specimen in the unit "nm", and the y axis represents the concentration in the unit "cm⁻³". The x axis is in linear scale and the y axis is in logarithmic scale. The curve d shows [Cu], the curve e shows [Ga], and the curve f shows [N].

The Cu concentration [Cu] was 7.5 x 10¹⁹ cm⁻³, and the Ga concentration [Ga] was 4.1 x 10¹⁹ cm⁻³ in the area corresponding to the position where the alternate laminate structure 65 had been formed (the position where the p-type layer had been formed), and both of these concentrations were approximately constant throughout the thickness direction of the p-type layer. The value of [Cu]/[Ga] was 1.8. The N concentration [N] in the N-doped p-type MgZnO layer 64 was 2.7 x 10²⁰ cm⁻³.

The decline of the [Cu] and the [Ga] was in the order of 10² or more in the N-doped p-type MgZnO layer 64, and the change of the concentration at the pn interface is steep. The diffusion of the Cu and the Ga to the side of the underlying layer (the undoped ZnO layer 63) was little observed. The graph demonstrates that the N-doped p-type MgZnO layer 64 suppresses the diffusion of the Cu and the Ga from the position where the alternate laminate structure 65 had been formed to the side of the undoped ZnO layer 63 (i.e., that the N-doped p-type MgZnO layer 64 blocks the Cu and Ga).

On the other hand, in the case of the N in the N-doped p-type MgZnO layer 64, some diffusion to both the side of the p-type layer (the range corresponding to the position where the alternate laminate structure 65 had been formed) and the side of the n-type layer (the undoped ZnO layer 63) was observed. The degree of the diffusion is higher on the side of the p-type layer.

FIG. 7C is a RHEED image of the alternate laminate structure from the [11-20] direction. The RHEED image exhibits a streak pattern, and this indicates formation of a single crystal layer having an even surface as well as good crystallinity. Conceivably, the surface evenness and crystallinity of the p-type layer formed by the annealing are further improved.

The second experiment has demonstrated that the annealing after forming the N-doped p-type MgZnO layer 64 between the alternate laminate structure 65 (the Ga-doped n-type ZnO single crystal layer having Cu supplied on the layer) and the undoped ZnO layer 63 enables conversion of the alternate laminate structure 65 to the p-type while suppressing the diffusion of the Cu and the Ga to the side of the undoped ZnO layer 63. The p-type layer formed by the annealing exhibits both the surface evenness and the good crystallinity.

In the second experiment, the N concentration (average) in the N-doped p-type MgZnO layer 64 was 2.7 x 10²⁰ cm⁻³. However, the effect of suppressing the diffusion of the Cu and the Ga to the side of the undoped ZnO layer 63 would be obtained by doping at least 1.0 x 10¹⁹ cm⁻³. When the N is doped at 1.0 x 10²⁰ cm⁻³ or more so that the N concentration is higher than the Ga concentration in the alternate laminate structure, more effective suppression of the diffusion of the Ga is enabled.

The experiment conducted by the inventors of the present invention demonstrated that annealing of the Ga-doped ZnO single crystal layer having Cu supplied on the layer surface(the alternate laminate structure prepared by alternately repeating the step of forming the Ga-doped ZnO single crystal layer and the Cu attaching step) results in the increase of the resistance and subsequent formation of the p-type ZnO layer co-doped with Cu and Ga. It was also found that the diffusion of the Cu and the Ga can be suppressed by placing a N-doped p-type MgZnO layer.

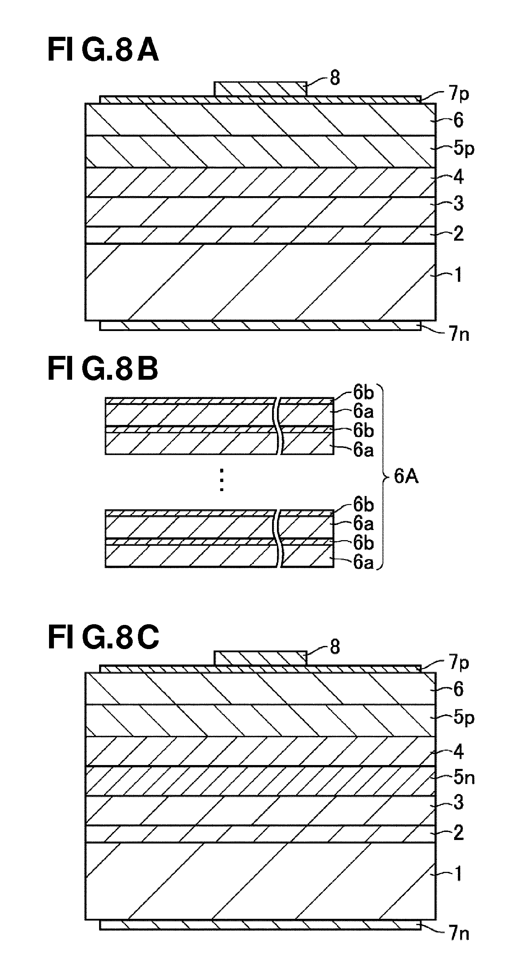

Next, production of a ZnO based compound semiconductor light emitting element by Example 1 prepared by using the ZnO layer co-doped with Cu and Ga for the p-type semiconductor layer and having a N-doped MgZnO layer for the diffusion preventive layer is described by referring to FIGS. 8A and 8B. Example 1 is a ZnO based compound semiconductor light emitting element having a homo-structure. It is to be noted that, while the semiconductor light emitting element is described in the Examples, the present invention is not limited to the light-emitting device, and the present invention can be applied to a wide variety of semiconductor elements.

First, the production method of the ZnO based compound semiconductor light emitting element of Example 1 is described.

As shown in FIG. 8A, a ZnO buffer layer 2 having a thickness of 30 nm was formed above a ZnO substrate 1 at a growth temperature of 300°C by using a Zn flux F_{Zn} of 0.15 nm/s (J_{Zn} = 9.9 x 10¹⁴ atoms/cm²s) and irradiating O radical beam at an RF power of 300 W and a O₂ flow rate of 2.0 sccm (J_{O}= 8.1 x 10¹⁴ atoms/cm²s). The ZnO buffer layer 2 was annealed at 900°C for 10 minutes for improving crystallinity and surface evenness of the ZnO buffer layer 2.

Zn, O, and Ga were simultaneously supplied above the ZnO buffer layer 2 at a growth temperature of 900°C to form an n-type ZnO layer 3 having a thickness of 150 nm. Zn was supplied at a Zn flux F_{Zn} of 0.15 nm/s (Jzn = 9.9 x 10¹⁴ atoms/cm²s), and the O radical beam was irradiated at an RF power of 250 W and an O₂ flow rate of 1.0 sccm (J_{O}= 4.0 x 10¹⁴ atoms/cm²s), and Ga cell temperature was 460°C. The n-type ZnO layer 3 had a Ga concentration of, for example, 1.5 x 10¹⁸ cm⁻³_{.}

An undoped ZnO active layer 4 having a thickness of 15 nm was deposited above the n-type ZnO layer 3 at a growth temperature of 900°C and a Zn flux F_{Zn} of 0.03 nm/s (J_{Zn} = 2.0 x 10¹⁴ atoms/cm²s). The O radical beam was irradiated at an RF power of 300 W and an O₂ flow rate of 2.0 sccm (J_{O}= 8.1 x 10¹⁴ atoms/cm²s).

A diffusion preventive layer 5p having a thickness of 10 nm constituted from a N-doped p-type MgZnO was formed above the undoped ZnO active layer 4 at the growth temperature of 700°C, the Zn flux F_{Zn} of 0.11 nm/s, the Mg flux F_{Mg} of 0.04 nm/s, the O radical beam irradiation conditions including the RF power of 300 W and the O₂ flow rate of 2.0 sccm (J_{O} = 8.1 x 10¹⁴ atoms/cm²s), and N radical beam irradiation conditions of the RF power of 100 W and the N₂ flow rate of 0.5 sccm (with the shutter closed). The VI/II flux ratio was 1.22. The Mg composition of the diffusion preventive layer 5p (the N-doped p-type MgZnO layer) was, for example, 0.32.

A Cu and Ga co-doped p-type ZnO layer 6 was formed above the diffusion preventive layer 5p.

First, substrate temperature was set to 300°C, and Ga-doped n-type ZnO single crystal film having Cu supplied on the surface was prepared by supplying Zn, O and Ga at a timing different from Cu at the same shutter sequence as the pre-annealing specimen of Sample 1 (see FIG. 2B). More specifically, each of the step of depositing a Ga-doped ZnO single crystal film by supplying Zn, O, and Ga and the step of supplying Cu on the Ga-doped ZnO single crystal film were alternately repeated for 140 times to form an alternate laminate structure having a thickness of 480 nm. In other words, the alternate laminate structure may be regarded as a laminate of 140 Ga-doped n-type ZnO single crystal films each supplied with Cu on its surface disposed one on another in thickness direction.

Each growth period for Ga-doped ZnO single crystal film was set at 16 seconds, and each Cu supplying period was 10 seconds. The Ga-doped ZnO single crystal film was deposited by using a Zn flux F_{Zn} of 0.17 nm/s (J_{Zn}= 1.1 x 10¹⁵ atoms/cm²s), and irradiating the O radical beam at an RF power of 300 W and an O₂ flow rate of 2.0 sccm (J_{O}= 8.1 x 10¹⁴ atoms/cm²s), and the Ga cell temperature T_{Ga} was 490°C. The VI/II flux ratio was 0.74. The cell temperature in the Cu supplying step T_{Cu} was 930°C, and the Cu flux F_{Cu} was 0.0015 nm/s.

FIG. 8B is a schematic cross sectional view of the alternate laminate structure 6A. The alternate laminate structure 6A has a structure wherein a Ga-doped ZnO single crystal films 6a and a Cu layers 6b are alternately laminated one on another (a structure wherein the Ga-doped ZnO single crystal films 6a having Cu supplied on the film surface are disposed one on another in thickness direction). The Ga-doped ZnO single crystal film 6a has a thickness of approximately 3.3 nm, and the Cu layer 6b has a thickness of up to 1 atomic layer, for example, about 1/20 atomic layer (so that approximately 5% of the surface of the Ga-doped ZnO single crystal film 6a is covered with Cu). The alternate laminate structure 6A (the Ga-doped ZnO single crystal film 6a having Cu supplied on the film) has n-type electroconductivity, and donor concentration N_{d} is, for example, about 1.0 x 10²⁰ cm⁻³.

Next, the Ga-doped ZnO single crystal film having Cu supplied on the film surface 6a (alternate laminate structure 6A) was annealed to form the Cu-doped p-type film (Cu and Ga co-doped p-type ZnO layer 6). For example, annealing may be conducted in the atmosphere at 650°C for 70 minutes to diffuse Cu of the Cu layer 6b into the Ga-doped ZnO single crystal film 6a to convert the alternate laminate structure 6A exhibiting n-type electroconductivity to the one exhibiting p-type. Under such annealing conditions, the Ga-doped ZnO single crystal film 6a is converted to the one exhibiting p-type through latent increase in the resistance.

Alternatively, the annealing may be conducted in the atmosphere at 650°C for 30 minutes to form a Ga-doped ZnO single crystal film 6a having a visually increased resistance, and then conducting additional annealing in the atmosphere at 650°C for 40 minutes to thereby form the Ga-doped ZnO single crystal film 6a exhibiting p-type electroconductivity.

An n electrode 7n was subsequently formed on the rear surface of the ZnO substrate 1. A p electrode 7p was formed on the Cu and Ga co-doped p-type ZnO layer 6, and a bonding electrode 8 was formed on the p electrode 7p. The n electrode 7n may be formed by depositing an Au layer having a thickness of 500 nm on a Ti layer having a thickness 10 nm. The p electrode 7p was formed by depositing a Au layer having a thickness of 10 nm on a Ni layer having a size of 300 µm square and a thickness of 1 nm, and the bonding electrode 8 was formed by depositing a Au layer having a size of 100 µm square and a thickness of 500 nm. The ZnO based compound semiconductor light emitting element of Example 1 was thereby formed.

FIG. 8A is a schematic cross sectional view of the ZnO based compound semiconductor light emitting element of Example 1. The ZnO based compound semiconductor light emitting element of Example 1 comprises an n-type ZnO based compound semiconductor layer (n-type ZnO layer 3), a ZnO based compound semiconductor active layer (an undoped ZnO active layer 4) formed above the n-type ZnO based compound semiconductor layer, a first p-type ZnO based compound semiconductor layer (a diffusion preventive layer 5p) formed above the ZnO based compound semiconductor active layer, a second p-type ZnO based compound semiconductor layer (a Cu and Ga co-doped p-type ZnO layer 6) formed above the first p-type ZnO based compound semiconductor layer, an n electrode (n electrode 7n) electrically connected to the n-type ZnO based compound semiconductor layer, and a p electrode (p electrode 7p) electrically connected the second p-type ZnO based compound semiconductor layer.

The Cu and Ga co-doped p-type ZnO layer 6 is a p-type ZnO based compound single crystal layer having Cu and Ga co-doped therewith. In the Cu and Ga co-doped p-type ZnO layer 6, the Cu concentration [Cu] and the Ga concentration [Ga] preferably the relation satisfy the relation: 1 < [Cu]/[Ga] < 100, and more preferably the relation: 2 ≤ [Cu]/[Ga] ≤ 50. More specifically, the Cu concentration [Cu] is at least 1.0 x 10¹⁹ cm⁻³ and less than 1.0 x 10²¹ cm⁻³, for example, 2.2 x 10²⁰ cm⁻³, and the [Cu] is approximately constant in the thickness direction. The Ga concentration [Ga] is, for example, 3.4 x 10¹⁹ cm⁻³, and the [Ga] is approximately constant in the thickness direction. The [Cu]/[Ga] is 6.5. The Cu and Ga co-doped p-type ZnO layer 6 in the semiconductor light emitting element of Example 1 is a p-type ZnO layer wherein the Cu is uniformly doped at a high concentration throughout its thickness, and it has the p-type electroconductivity of practical level. The Cu and Ga co-doped p-type ZnO layer 6 can be formed by annealing the Ga-doped ZnO single crystal film 6a exhibiting n-type electroconductivity at a low temperature, and it has surface evenness and good crystallinity.

The diffusion preventive layer 5p is a p-type layer constituted from a N-doped MgZnO. The N concentration [N] in the diffusion preventive layer 5p is at least 1.0 x 10¹⁹ cm⁻³, for example, 2.7 x 10²⁰ cm⁻³. The diffusion preventive layer 5p prevents diffusion of the Cu and Ga from the alternate laminate structure 6A to the side of the undoped ZnO active layer 4 in the production of the ZnO based compound semiconductor light emitting element of the Example 1, for example, in the formation of the Cu and Ga co-doped p-type ZnO layer 6 by the annealing of the alternate laminate structure 6A. Since the diffusion of the Cu and the Ga is prevented, thickness of the undoped ZnO active layer 4 is retained and loss of the crystalline quality is prevented. Formation of the defects which will be the nonluminescent center in the undoped ZnO active layer 4 is also prevented, and the semiconductor light emitting element having high light emission efficiency is thereby produced. The [Cu] and the [Ga] decreases in the diffusion preventive layer 5p, for example, by the order of 10² or more (The [Cu] and the [Ga] respectively differs between the side of the Cu and Ga co-doped p-type ZnO layer 6 and the side of the undoped ZnO active layer 4 in the diffusion preventive layer 5p by the order of 10² or more). Accordingly, change in the concentration at the pn interface is steep in the ZnO based compound semiconductor light emitting element of the Example 1.

As described above, the ZnO based compound semiconductor light emitting element of Example 1 is a high quality semiconductor light emitting element.

FIG. 8C is a schematic cross sectional view of the ZnO based compound semiconductor light emitting element according to the modification of the Example 1. This modification of the Example 1 is different from the Example 1 in that the diffusion preventive layer 5n is disposed between the Ga-doped n-type ZnO layer 3 and the undoped ZnO active layer 4. The diffusion preventive layer 5n is constituted from, for example, a N-doped ZnO, and it prevents diffusion of the Ga (the n-type dopant) of the n-type ZnO layer 3 to the side of the undoped ZnO active layer 4 in the production of the semiconductor light emitting element, and it also has the function of retaining the thickness of the undoped ZnO active layer 4 and suppressing the loss of crystalline quality. The diffusion preventive layer 5n may be formed, for example, at a growth temperature of at least 800°C and up to 1000°C and at a VI/II flux of up to 1.

As an embodiment, the diffusion preventive layer 5n may be formed above the n-type ZnO layer 3 to a thickness of 50 nm by using the growth temperature of 900°C, the Zn flux F_{Zn} of 0.3 nm/s (J_{Zn} = 2.0 x 10¹⁵ atoms/cm²s), the O radical beam irradiation conditions including the RF power of 250 W and the O₂ flow rate of 1.0 sccm (J_{O} = 4.0 x 10¹⁴ atoms/cm²s), and N radical beam irradiation conditions including the RF power of 140 W and the N₂ flow rate of 1.0 sccm. The VI/II flux ratio is 0.22. The undoped ZnO active layer 4 is formed above the diffusion preventive layer 5n. The conditions used for the formation of layers other than the diffusion preventive layer 5n are the same as the Example 1.

The diffusion preventive layer 5n exhibits n-type electroconductivity. N element functions as an acceptor when it replaces O site of the ZnO. However it may be incorporated in the form of N₂ molecule or the like. The N₂ molecule in the ZnO behaves as a double donor, and the diffusion preventive layer 5n becomes an n-type layer. The growth conditions such as the VI/II flux ratio and the growth temperature may be adequately determined to define the behavior of the N as the acceptor or the donor.

The diffusion preventive layer 5n may also be formed from a N-doped n-type MgZnO, and the layer may be formed to a thickness of 50 nm, for example, by using the growth temperature of 950°C, the Zn flux F_{Zn} of 0.3 nm/s, the Mg flux F_{Mg} of 0.01 nm/s, the O radical beam irradiation conditions including the RF power of 250 W and the O₂ flow rate of 1.0 sccm, and the N radical beam irradiation condition including the RFpower of 140 W and the N₂ flow rate of 1.0 sccm. VI/II flux ratio will be 0.32. The Mg composition of the N-doped n-type MgZnO layer is, for example, 0.2.

In the modification, the diffusion preventive layer 5n is adjacent to the n-type ZnO layer 3 and the undoped ZnO active layer 4. However, the diffusion preventive layer 5n does not have to be in contact with these layers as long as the diffusion preventive layer 5n is between these layers.

It is to be noted that, while the Ga doped n-type ZnO layer 3 was formed in Example 1, N may be used as the n-type dopant of the ZnO layer 3 as described, for example, in Japanese Patent Application Laid Open No. 2011-134787. In this case, the diffusion as in the case of using Ga for the n-type dopant can be suppressed even in the absence of the diffusion preventive layer 5n.

In the experiments, Example 1, and the modification of the Example 1, the layer formed was the Cu and Ga co-doped p-type ZnO layer. A Cu-doped p-type film (Cu and Ga co-doped p-type MgₓZn₁₋ₓO(0 < x ≤ 0.6) single crystal film) may also be produced by annealing a Ga-doped n-type MgₓZn₁₋ₓO(0 < x ≤ 0.6) single crystal film having Cu supplied on the film surface.

An exemplary preparation of a Ga-doped n-type MgₓZn₁₋ₓO(0 < x ≤ 0.6) single crystal film having Cu supplied on the film surface is explained. The film prepared is an alternate laminate structure comprising alternately deposited Ga-doped n-type MgₓZn_{1-X}O(0 < x ≤ 0.6) single crystal film and Cu layer.

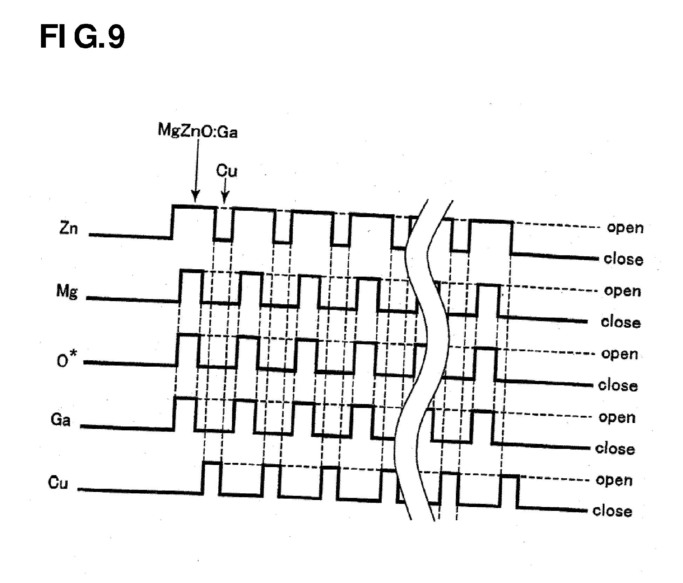

FIG. 9 is a time chart of an exemplary shutter sequence of the Zn cell, the Mg cell, the O cell, the Ga cell, and the Cu cell during formation of the alternate laminate structure.

In the formation of the alternate laminate structure, the step of depositing the Ga-doped MgₓZn₁₋ₓO(0 < x ≤ 0.6) single crystal film conducted by opening the Zn cell shutter, the Mg cell shutter, the O cell shutter, and the Ga cell shutter while closing the Cu cell shutter, and the Cu attaching step conducted by closing the Zn cell shutter, the Mg cell shutter, the O cell shutter, and the Ga cell shutter while opening the Cu cell shutter are alternately repeated.

In the case shown in FIG. 9, the step of forming the Ga-doped MgₓZn₁₋ₓO single crystal film is designed so that the period when Zn cell shutter is open include the period when the Mg cell shutter, the O cell shutter, and the Ga cell shutter are open. More specifically, opening and closing of the Mg cell shutter, the O cell shutter, and the Ga cell shutter are simultaneously conducted while the Zn cell shutter is opened before the opening of the Mg cell shutter, the O cell shutter, and the Ga cell shutter and closed after the closing of the Mg cell shutter, the O cell shutter, and the Ga cell shutter.

For example, each open period of the Mg cell shutter, the O cell shutter, and the Ga cell shutter is 16 seconds. The Zn cell shutter is opened and closed 1 second before and after the open period of the Mg cell shutter, the O cell shutter, and the Ga cell shutter, and therefore, each open period of the Zn cell shutter is 18 seconds. The 16 seconds when all of the Zn cell shutter, the Mg cell shutter, the O cell shutter, and the Ga cell shutter is each growth period of the Ga-doped MgₓZn₁₋ₓO single crystal film. Each open period of the Cu cell shutter was 10 seconds.

Since simultaneous supplying of the O radical and the Cu is avoided and the surface of the Ga-doped MgₓZn₁₋ₓO single crystal film is covered with Zn before and after the Cu attachment step, direct reaction between the O radical and the Cu is suppressed.

When Mg is supplied with Zn, at least one of the open period of the Zn cell shutter and the open period of the Mg cell shutter preferably includes the open period of the O cell shutter in view of suppressing the reaction the O radical and the Cu. In addition, in view of controlling Mg composition in the Ga-doped MgₓZn₁₋ₓO single crystal film, the open period of the Zn cell shutter should preferably include the open period of the Mg cell shutter and O cell shutter.

Annealing of the Ga-doped n-type MgₓZn₁₋ₓO(0 < x ≤ 0.6) single crystal film having the Cu supplied on the film surface (the alternate laminate structure) results in the increase of the resistance, and then, in the production of the Cu and Ga co-doped p-type MgₓZn₁₋ₓO(0 < x ≤ 0.6) single crystal film.

Next, a ZnO based compound semiconductor light emitting element of double hetero structure having a Cu and Ga co-doped p-type MgₓZn₁₋ₓO(0 < x ≤ 0.6) single crystal layer, and having a N-doped p-type MgZnO layer as the diffusion preventive layer according to Examples 2 and 3 are described.

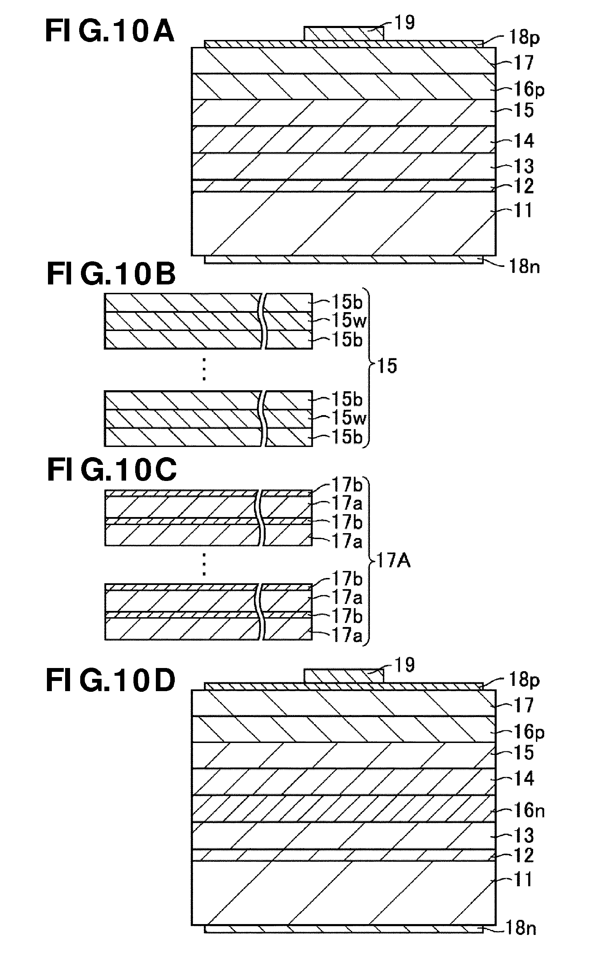

The production method of the ZnO based compound semiconductor light emitting element of Example 2 is explained by referring to FIGS. 10A to 10C.

As shown in FIG.10A, Zn and O were simultaneously supplied above the surface of the ZnO substrate 11 to deposit a ZnO buffer layer 12 having a thickness of, for example, 30 nm. Exemplary conditions used in depositing the ZnO buffer layer 12 include a growth temperature of 300°C, a Zn flux F_{Zn} of 0.15 nm/s, and the O radical beam irradiation at an RF power 300 W and an O₂ flow rate of 2.0 sccm. Annealing at 900°C for 10 minutes was conducted to improve crystallinity and surface evenness of the ZnO buffer layer 12.

Zn, O, and Ga were simultaneously supplied above the surface of the ZnO buffer layer 12 to deposit an n-type ZnO layer 13 having a thickness of 150 nm, for example, at a temperature of 900°C. The Zn flux F_{Zn} was 0.15 nm/s and the O radical beam was irradiated at an RF power of 250 W and an O₂ flow rate of 1.0 sccm, and Ga cell temperature was 460°C. The n-type ZnO layer 13 had a Ga concentration of, for example, 1.5 x 10¹⁸ cm⁻³.

Zn, Mg, and O were simultaneously supplied above the surface of the n-type ZnO layer 13 to deposit an n-type MgZnO layer 14 having a thickness of, for example, 30 nm. Exemplary conditions used in the deposition include a temperature of 900°C, a Zn flux F_{Zn} of 0.1 nm/s, a Mg flux F_{Mg} of 0.025 nm/s, and the O radical beam irradiation at an RF power of 300 W and an O₂ flow rate of 2.0 sccm. The Mg composition of the n-type MgZnO layer 14 is, for example, 0.3.

Zn and O were simultaneously supplied above the surface of the on the n-type MgZnO layer 14 to deposit a ZnO active layer 15 having a thickness 10 nm at a temperature of 900°C. The Zn flux F_{Zn} was 0.1 nm/s, and the O radical beam was irradiated at an RF power of 300 W and an O₂ flow rate of 2.0 sccm.

As shown in FIG. 10B, the active layer 15 may comprise a quantum well structure formed by alternately depositing a MgZnO barrier layer 15b and a ZnO well layer 15w one on another instead of the single layer ZnO layer.

Zn, Mg, O, and N were simultaneously supplied above the active layer 15 to deposit a diffusion preventive layer 16p constituted from the N-doped p-type MgZnO having a thickness 10 nm. The deposition could be conducted at the growth temperature of 700°C, the Zn flux F_{Zn} of 0.11 nm/s, the Mg flux F_{Mg} of 0.04 nm/s, the O radical beam irradiation conditions including the RF power of 300 W and the O₂ flow rate of 2.0 sccm, the N radical beam irradiation conditions including the RF power of 100W and the N₂ flow rate of 0.5 sccm (with the shutter closed). The VI/II flux ratio was 1.22. The Mg composition of the diffusion preventive layer 16p (the N-doped p-type MgZnO layer) was, for example, 0.32.

An alternate laminate structure was formed above the diffusion preventive layer 16p by reducing the substrate temperature, for example, to 300°C and alternately repeating the step of depositing the Ga-doped MgZnO single crystal film and the Cu attachment step. The shutter sequence of the Zn cell, the Mg cell, the O cell, the Ga the cell, and Cu cell used in forming the alternate laminate structure may be, for example, the same as the one shown in FIG. 9.

For example, each growth period in the step of depositing the Ga-doped MgZnO single crystal film was 16 seconds, and each Cu supplying period in the Cu attachment step was 10 seconds. In the step of depositing the Ga-doped MgZnO single crystal film, the Zn flux F_{Zn} was 0.15 nm/s, the Mg flux F_{Mg} was 0.03 nm/s, and the O radical beam was irradiated at an RF power of 300 W and an O₂ flow rate of 2.0 sccm, and the Ga cell temperature T_{Ga} was 498°C. The VI/II flux ratio was 0.72. In the step of supplying Cu, the Cu cell temperature T_{Cu} was 930°C and the Cu flux F_{Cu} was 0.0015 nm/s. Each of the step of depositing the Ga-doped MgZnO single crystal film and the Cu attachment steps were alternately repeated for 60 times to deposit an alternate laminate structure having a thickness of 200 nm. The alternate laminate structure may also be deemed as a laminate prepared by disposing 60 layers of the Ga-doped n-type MgZnO single crystal film having Cu supplied on the film surface in the thickness direction.

FIG. 10C is a schematic cross sectional view of the alternate laminate structure 17A. The alternate laminate structure 17A has a structure wherein a Ga-doped MgZnO single crystal films 17a and a Cu layers 17b are alternately laminated one on another (a structure wherein the Ga-doped MgZnO single crystal films 17a having Cu supplied on the film surface are disposed one on another in thickness direction). The Ga-doped MgZnO single crystal film 17a has a thickness of approximately 3.3 nm, and the Cu layer 17b has a thickness of up to 1 atomic layer, for example, about 1/20 atomic layer (so that approximately 5% of the surface of the Ga-doped MgZnO single crystal film 17a is covered with Cu). The alternate laminate structure 17A (the Ga-doped MgZnO single crystal film 17a having Cu supplied on the film) has n-type electroconductivity, and donor concentration N_{d} is, for example, about 7.5 x 10¹⁹ cm⁻³_{.}

Next, a Cu-doped p-type film (the Cu and Ga co-doped p-type MgZnO layer 17) was formed above the diffusion preventive layer 16p by annealing the Ga-doped MgZnO single crystal film 17a having Cu supplied on the film surface (the alternate laminate structure 17A). The alternate laminate structure 17A showing n-type electroconductivity may be converted to exhibit p-type by diffusing Cu in the Cu layer 17b into the Ga-doped MgZnO single crystal film 17a by conducting the annealing, for example, in the atmosphere at 650°C for 20 minutes. Under such annealing conditions, the Ga-doped MgZnO single crystal film 17a is converted to the one exhibiting p-type through latent increase in the resistance.

Alternatively, the Ga-doped MgZnO single crystal film 17a may be converted to exhibit p-type by conducting the annealing, for example, in the atmosphere at 650°C for 10 minutes to visually increase resistance of the Ga-doped MgZnO single crystal film 17a, and further annealing in the atmosphere at 650°C for 10 minutes.

Mg composition in the Cu and Ga co-doped p-type MgZnO layer 17 is, for example, 0.3.

An n electrode 18n was formed on the rear surface of the ZnO substrate 11. A p electrode 18p was formed on the Cu and Ga co-doped p-type MgZnO layer 17, and a bonding electrode 19 was formed on the p electrode 18p. The n electrode 18n may be formed, for example, by depositing an Au layer having a thickness 500 nm on a Ti layer having a thickness of 10 nm, and the p electrode 18p was formed by depositing a Au layer having a thickness of 10 nm on a Ni layer having a size of 300 µm square and a thickness of 1 nm, and the bonding electrode 19 was formed by depositing a Au layer having a size of 100 µm square to a thickness of 500 nm. The ZnO based compound semiconductor light emitting element of Example 2 was thereby formed.

In Example 2, the ZnO based compound semiconductor light emitting element was produced by using the ZnO substrate 11. However, the element may also be prepared by using an electroconductive substrate such as MgZnO substrate, GaN substrate, SiC substrate, and Ga₂O₃ substrate.

FIG. 10A is a schematic cross sectional view of the ZnO based compound semiconductor light emitting element of Example 2. The ZnO based compound semiconductor light emitting element of the Example 2 comprises an n-type ZnO based compound semiconductor layer (for example, an n-type ZnO layer 13), a ZnO based compound semiconductor active layer (an active layer 15) formed above the n-type ZnO based compound semiconductor layer, a first p-type ZnO based compound semiconductor layer (a diffusion preventive layer 16p) formed above the ZnO based compound semiconductor active layer, a second p-type ZnO based compound semiconductor layer (a Cu and Ga co-doped p-type MgZnO layer 17) formed above the first p-type ZnO based compound semiconductor layer, an n electrode (n electrode 18n) electrically connected to the n-type ZnO based compound semiconductor layer, and a p electrode (p electrode 18p) electrically connected to the second p-type ZnO based compound semiconductor layer.

The Cu and Ga co-doped p-type MgZnO layer 17 is a p-type ZnO based compound single crystal layer co-doped with Cu and Ga. In the Cu and Ga co-doped p-type MgZnO layer 17, the Cu concentration [Cu] and the Ga concentration [Ga] preferably satisfy the relation: 1 < [Cu]/[Ga] < 100, and more preferably the relation: 2 ≤ [Cu]/[Ga] ≤ 50. More specifically, the Cu concentration [Cu] is at least 1.0 x 10¹⁹ cm⁻³ and less than 1.0 x 10²¹ cm⁻³, for example, 2.0 x 10²⁰ cm⁻³, and the Cu concentration [Cu] is approximately constant in the thickness direction. The Ga concentration [Ga] is, for example, 3.6 x 10¹⁹ cm⁻³, and the Ga concentration [Ga] is approximately constant in the thickness direction. The [Cu]/[Ga] is 5.6. The Cu and Ga co-doped p-type MgZnO layer 17 in the semiconductor light emitting element of Example 2 is a p-type MgZnO layer wherein Cu is evenly doped throughout its thickness at a high Cu concentration, and it has p-type electroconductivity of practical level. The Ga-doped MgZnO single crystal film 17a exhibiting n-type electroconductivity can be converted to a p-type film by annealing at low temperature, and the resulting film may exhibit surface evenness and good crystallinity.

The diffusion preventive layer 16p is a p-type layer constituted from a N-doped MgZnO. The N concentration [N] in the diffusion preventive layer 16p is at least 1.0 x 10¹⁹ cm⁻³, for example, 2.7 x 10²⁰ cm⁻³. The diffusion preventive layer 16p prevents diffusion of the Cu and Ga from the alternate laminate structure 17A to the side of the active layer 15 in the production of the ZnO based compound semiconductor light emitting element of the Example 2, for example, in the formation of the Cu and Ga co-doped p-type MgZnO layer 17 by the annealing of the alternate laminate structure 17A. Since the diffusion of the Cu and the Ga is prevented, thickness of the layer 15 is retained and loss of the crystalline quality is prevented. Formation of the defects which will be the nonluminescent center in the active layer 15 is also prevented, and the semiconductor light emitting element having high light emission efficiency is thereby produced. The [Cu] and the [Ga] decrease in the diffusion preventive layer 16p, for example, by the order of 10² or more (The [Cu] and the [Ga] respectively differs between the side of the Cu and Ga co-doped p-type MgZnO layer 17 and the side of the active layer 15 in the diffusion preventive layer 16p by the order of 10² or more). Accordingly, change in the concentration at the pn interface is steep in the ZnO based compound semiconductor light emitting element of the Example 2.

As described above, the ZnO based compound semiconductor light emitting element of Example 2 is a high quality semiconductor light emitting element.

FIG. 10D is a schematic cross sectional view of the ZnO based compound semiconductor light emitting element of the modification of the Example 2. The modification of the Example 2 is different from the Example 2 in that it includes the diffusion preventive layer 16n between the n-type ZnO layer 13 and the active layer 15, for example, between the n-type ZnO layer 13 and the n-type MgZnO layer 14.

The diffusion preventive layer 16n is, for example, an n-type layer constituted from N-doped ZnO or N-doped MgZnO, and it prevents diffusion of the Ga (n-type dopant) of the n-type ZnO layer 13 to the side of the active layer 15 in the production of the semiconductor light emitting element, and it also has the function of retaining the thickness of the undoped ZnO active layer 15 and suppressing the loss of crystalline quality. The diffusion preventive layer 16n can be formed by the procedure similar to the diffusion preventive layer 5n in the modification of the Example 1.

It is to be noted that, when not Ga but N is used for the n-type dopant of the n-type ZnO layer 13, the diffusion as seen with the use of Ga for the n-type dopant can be suppressed without forming the diffusion preventive layer 16n.

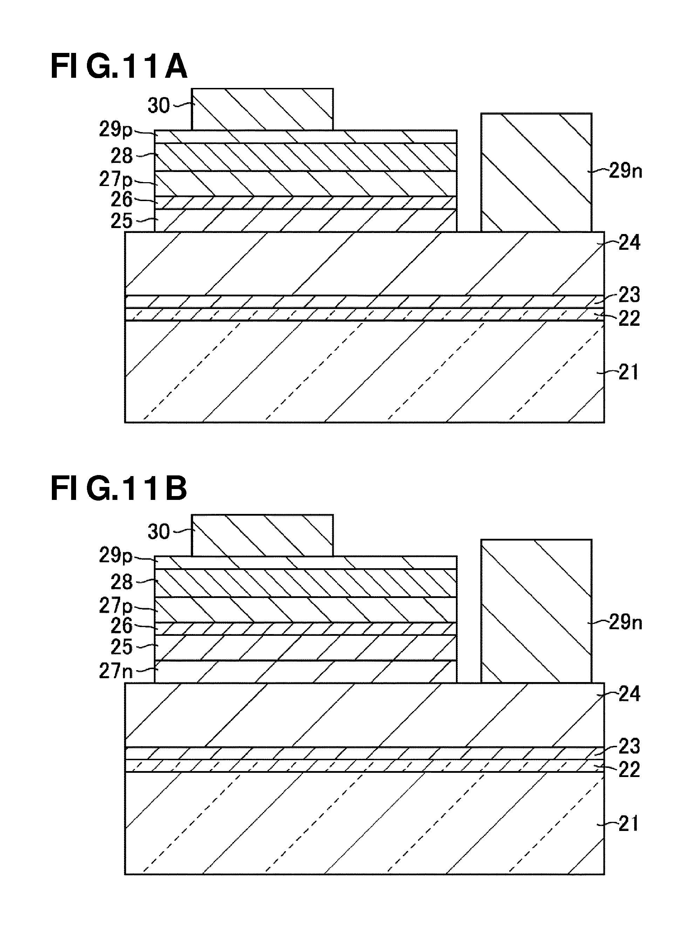

Next, the production method of the ZnO based compound semiconductor light emitting element by Example 3 is described by referring to FIG. 11A. In Examples 1 and 2 and their modifications, the semiconductor layer was formed above the electroconductive substrate. In Example 3, the semiconductor layer was formed above an insulated substrate.

Mg and O are simultaneously supplied above a c face sapphire substrate 21 which is an insulated substrate to deposit a MgO buffer layer 22 having, a thickness of, for example, 10 nm. In an exemplary embodiment, the MgO buffer layer 22 may be deposited at a temperature of 650°C with a Mg flux F_{Mg} of 0.05 nm/s by irradiating the O radical beam at an RF power of 300 W and an O₂ flow rate of 2.0 sccm. The MgO buffer layer 22 functions as a polarity control layer which facilitates deposition of the overlying ZnO based compound semiconductor layer with the Zn face as its surface.

Zn and O are simultaneously supplied above the MgO buffer layer 22 to deposit a ZnO buffer layer 23 having a thickness of 30 nm, for example, at a temperature of 300°C and a Zn flux F_{Zn} of 0.15 nm/s by irradiating the O radical beam at an RF power of 300 W and an O₂ flow rate of 2.0 sccm. The ZnO buffer layer 23 deposits at the Zn face. Annealing is conducted at 900°C for 30 minutes to improve crystallinity and surface evenness of the ZnO buffer layer 23.

Zn, O and Ga are simultaneously supplied above the ZnO buffer layer 23 to deposit an n-type ZnO layer 24 having a thickness of, for example, 1.5 µm. In an exemplary embodiment, the n-type ZnO layer 24 is deposited at a temperature of 900°C and a Zn flux F_{Zn} of 0.05 nm/s by irradiating the O radical beam at an RF power of 300 W and an O₂ flow rate of 2.0 sccm, with the Ga cell at a temperature of 480°C.

Zn, Mg, and O are simultaneously supplied above the n-type ZnO layer 24 to deposit an n-type MgZnO layer 25 having a thickness of, for example, 30 nm. The n-type MgZnO layer 25 may be deposited at a temperature of 900°C, a Zn flux F_{Zn} of 0.1 nm/s, and a Mg flux F_{Mg} of 0.025 nm/s by irradiating the O radical beam at an RF power of 300 W and an O₂ flow rate of 2.0 sccm. Mg composition of the n-type MgZnO layer 25 is, for example, 0.3.

A ZnO active layer 26 having a thickness of, for example, 10 nm is deposited above the n-type MgZnO layer 25. The conditions used for the deposition may be the same as the deposition of the active layer 15 in Example 2. A quantum well structure may be employed instead of the monolayer ZnO layer.

A diffusion preventive layer 27p constituted from a N-doped p-type MgZnO is deposited above the active layer 26 under the growth conditions the same as, for example, the diffusion preventive layers 5p and 16p of Examples 1 and 2.

A Cu and Ga co-doped p-type MgZnO layer 28 is formed above the diffusion preventive layer 27p. The method used may be, for example, the same as the method used in the formation of the Cu and Ga co-doped p-type MgZnO layer 17 used in Example 2.

The c face sapphire substrate 21 of Example 3 is an insulating substrate, and the n electrode can not be formed on the rear surface of the substrate 21. Accordingly, the Cu and Ga co-doped p-type MgZnO layer 28 is etched from its upper surface until the n-type ZnO layer 24 is exposed to thereby form an n electrode 29n on the thus exposed n-type ZnO layer 24. In the meanwhile, a p electrode 29p is formed on the Cu and Ga co-doped p-type MgZnO layer 28, and a bonding electrode 30 is formed on the p electrode 29p.

The n electrode 29n is formed by depositing a Au layer having a thickness of 500 nm on a Ti layer having a thickness of 10 nm, and the p electrode 29p is formed by depositing a Au layer having a thickness of 10 nm on a Ni layer having a thickness of 0.5 nm. The bonding electrode 30 is formed by a Au layer having a thickness of 500 nm. The ZnO based compound semiconductor light emitting element of Example 3 was thereby formed.

FIG. 11A is a schematic cross sectional view of the ZnO based compound semiconductor light emitting element of Example 3. As in the cases of Examples 1 and 2, the ZnO based compound semiconductor light emitting element of Example 3 also comprises an n-type ZnO based compound semiconductor layer (for example, the n-type ZnO layer 24), a ZnO based compound semiconductor active layer (the active layer 26) formed above the n-type ZnO based compound semiconductor layer, a first p-type ZnO based compound semiconductor layer (the diffusion preventive layer 27p) formed above the ZnO based compound semiconductor active layer, a second p-type ZnO based compound semiconductor layer (the Cu and Ga co-doped p-type MgZnO layer 28) formed above the first p-type ZnO based compound semiconductor layer, an n electrode (the n electrode 29n) electrically connected to the n-type ZnO based compound semiconductor layer, and a p electrode (the p electrode 29p) electrically connected to the second p-type ZnO based compound semiconductor layer.

The Cu and Ga co-doped p-type MgZnO layer 28 of Example 3 has similar properties as the Cu and Ga co-doped p-type MgZnO layer 17 of Example 2. The diffusion preventive layer 27p of Example 3 has similar properties and functions as diffusion preventive layers 5p and 16p of Examples 1 and 2.

The ZnO based compound semiconductor light emitting element of Example 3 is also a high quality semiconductor light emitting element.

FIG. 11B is a schematic cross sectional view of the ZnO based compound semiconductor light emitting element according to the modification of the Example 3. This modification of the Example 3 is different from the Example 3 in that the diffusion preventive layer 27n is disposed between the n-type ZnO layer 24 and the active layer 26, for example, between the n-type ZnO layer 24 and the n-type MgZnO layer 25.

The diffusion preventive layer 27n is an n-type layer constituted from, for example, a N-doped ZnO or a N-doped MgZnO, and it can be formed as in the case of the diffusion preventive layer 16n prepared in the modification of the Example 2 to have similar functions.

It t is to be noted that, when not Ga but N is used for the n-type dopant of the n-type ZnO layer 24, the diffusion found in the use of Ga for the n-type dopant can be suppressed without forming the diffusion preventive layer 27n.

The present invention has been described by referring to Experiments, Examples, and Modifications. The present invention, however, is not limited by these Experiments, Examples, and Modifications.

For example, in the production of the ZnO based compound semiconductor light emitting element in the Examples and their modifications, the O radical was used for the oxygen source. However, ozone, H₂O, alcohol, and other polar oxidizing agents as well as other highly oxidative gases may also be used for the oxygen source. In addition, while the N₂ gas in the form of plasma was used for the nitrogen source, a gas mixture prepared by adding O₂ gas to the N₂ gas may also be used as described, for example, in Japanese Patent Application Laid Open No. 2011-96884. Furthermore, while the Ga-doped n-type MgₓZn₁₋ₓO (0 ≤ x ≤ 0.6) single crystal film with Cu supplied on its surface was formed by MBE method, the film may also be formed, for example, by vacuum deposition, sputtering, or the like. Furthermore, while the annealing was conducted in the atmosphere, the annealing may also be conducted in oxygen or other atmosphere.

In addition, in the Experiments, Examples, and Modifications, the Ga-doped n-type MgₓZn₁₋ₓO(0 ≤ x ≤ 0.6) single crystal film having Cu supplied on the film surface was annealed to form the Cu-doped p-type layer (Cu and Ga co-doped p-type MgₓZn₁₋ₓO(0 ≤ x ≤ 0.6) single crystal layer). When the Ga (a Group 13 element)-doped n-type MgₓZn₁₋ₓO single crystal film having the Cu (Group 11 element) attached is annealed, binding of the Cu in its monovalent state (Cu⁺) with O which is a Group 16 element is facilitated, and this results in the higher tendency of the generation of the monovalent Cu⁺ which functions as an acceptor compared to the divalent Cu²⁺, and hence, conversion of the Ga-doped n-type MgₓZn₁₋ₓO single crystal film to the p-type. Accordingly, Ag which is a Group 11 element which may have different valances as in the case of Cu may be used instead of Cu or simultaneously with the Cu. Similarly, a Group 13 element such as B, Al, or In can be used for the Ga, and the Group 13 element used may be a Group 13 element selected from the group consisting of B, Ga, Al, and In.

In addition, in the Examples and their modifications, the Ga doped n-type MgₓZn₁₋ₓO(0 ≤ x ≤ 0.6) single crystal film was formed to a thickness of about 3.3 nm. However, a p-type MgₓZn₁₋ₓO(0 ≤ x ≤ 0.6) single crystal layer co-doped with Cu and Ga having high surface evenness and good crystallinity can be obtained by forming the film to a thickness of up to 10 nm.

In addition, in the Examples and their modifications, the VI/II flux ratio used in the step of depositing the Ga-doped n-type MgₓZn₁₋ₓO(0 ≤ x ≤ 0.6) single crystal film was 0.72 to 0.74. However, a high surface evenness and good crystallinity can be realized for the p-type MgₓZn₁₋ₓO(0 ≤ x ≤ 0.6) single crystal layer co-doped with Cu and Ga by using the VI/II flux ratio of up to 1, and more preferably at least 0.5 and less than 1.

In addition, in the Examples and their modifications, the growth temperature of 300°C was used in the step of depositing the Ga-doped n-type MgₓZn₁₋ₓO(0 ≤ x ≤ 0.6) single crystal film. However, a p-type MgₓZn₁₋ₓO(0 ≤ x ≤ 0.6) single crystal layer co-doped with Cu and Ga having high surface evenness and good crystallinity can be obtained by depositing the film at a temperature of at least about 200°C to up to 350°C.

In addition, in the Experiments and Examples and their modifications, the growth temperature of 700°C was used for the N-doped p-type MgZnO layer (the diffusion preventive layer). However, the N-doped p-type MgZnO layer can be deposited at a growth temperature of at least 300°C and less than 800°C. The element N functions as an acceptor in the replacement of the Zn site, and when the Zn site is replaced by N in the form of N₂ molecule, it the N₂ behaves as a double donor. When the growth temperature is at a high temperature of 800°C or more, N₂ molecule is more likely to be formed in the ZnO by the heat energy.

In addition, in the Experiments and Examples and their modifications, the VI/II flux ratio in the formation of the N-doped p-type MgZnO layer was 1.22. However, the VI/II flux ratio may be greater than 1 and up to 2 since N atom is not incorporated in the film under extreme O rich conditions, and N is excessively incorporated to form the N₂ molecule and the donor deficiency such as O vacancy and interstitial Zn increases to compensate the acceptor to reduce p-type electroconductivity under Zn rich conditions (Group II rich conditions).

In addition, the p-type diffusion preventive layer was prepared by doping N to the MgZnO layer. However, at least one element selected from the group consisting of N, P, As, and Sb (Group VB elements) may be used for the p-type dopant. These elements have the function of reducing the diffusion of the dopant (Cu and Ga in the Experiments and Examples, and their modifications) in the conversion into the p-type of the alternate laminate structure, for example, by annealing.

In addition, in the Examples and their modifications, the p-type diffusion preventive layer was formed as a N-doped MgₓZn₁₋ₓO(0 < x ≤ 0.6) layer. The p-type diffusion preventive layer, however, may be formed as not only as a ZnO layer (MgₓZn₁₋ₓO wherein x = 0), but also as various ZnO based compound semiconductor layers such as CdₐZn₁₋ₐO layer, BeₐZn₁₋ₐO layer, and CaₐZn₁₋ₐO layer (wherein 0 < a < 1),and ZnO_{1-b}S_{b} layer, ZnO_{1-b}Se_{b} layer, and ZnO_{1-b}Te_{b} layer (wherein 0 < b <1).

As readily understood by those skilled in the art, various modifications, improvements, combinations, and the like are possible for the present invention.

The p-type ZnO based compound semiconductor layer of Examples and Modifications may be used, for example, in a light emitting diode (LED) or a laser diode (LD) emitting a light having a short wavelength (the wavelength range of ultraviolet to blue), various products produced by such LED or LD (for example, indicators, LED displays, and light source for CV/DVD), and also, in white LED and various products produced using such while LED (for example, light fixtures, indicators, displays, and backlight of various displays), and ultraviolet sensor.

## Claims

1. A method for producing a ZnO based compound semiconductor element comprising the steps of
(a) forming an n-type ZnO based compound semiconductor layer above a substrate,
(b) forming a ZnO based compound semiconductor active layer above the n-type ZnO based compound semiconductor layer,
(c) forming a first p-type ZnO based compound semiconductor layer above the ZnO based compound semiconductor active layer, and
(d) forming a second p-type ZnO based compound semiconductor layer above the first p-type ZnO based compound semiconductor layer, wherein
the step (d) comprises the steps of
(d1) forming an n-type MgₓZn₁₋ₓO(0 ≤ x ≤ 0.6) single crystal film having a Group 11 element which is Cu and/or Ag supplied on its surface and doped with a Group 13 element which is at least one element selected from the group consisting of B, Ga, Al, and In, and
(d2) annealing the n-type MgₓZn₁₋ₓO(0 ≤ x ≤ 0.6) single crystal film having the 11 element supplied on its surface for conversion into a p-type film doped with the 11 element, and
the first p-type ZnO based compound semiconductor layer doped an element which reduces diffusion of the Group 11 element and the Group 13 element is formed in the step (c).

2. A method for producing a ZnO based compound semiconductor element according to claim 1 wherein at least one element selected from the group consisting of N, P, As, and Sb is used in the step (c) as a p-type dopant.

3. A method for producing a ZnO based compound semiconductor element according to claim 1 wherein the first p-type ZnO based compound semiconductor layer is constituted from a N-doped MgZnO in the step (c).

4. A method for producing a ZnO based compound semiconductor element according to claim 1 or 3 wherein the first p-type ZnO based compound semiconductor layer is doped with at least 1.0 x 10¹⁹ cm⁻³ of N in the step (c).

5. A method for producing a ZnO based compound semiconductor element according to any one of claims 1 to 4 wherein the first p-type ZnO based compound semiconductor layer is formed at a temperature of at least 300°C and less than 800°C in the step (c).

6. A method for producing a ZnO based compound semiconductor element according to any one of claims 1 to 5 wherein the first p-type ZnO based compound semiconductor layer is formed in the step (c) at the VI/II flux ratio of more than 1 and up to 2.

7. A method for producing a ZnO based compound semiconductor element according to any one of claims 1 to 5 wherein the n-type MgₓZn₁₋ₓO(0 ≤ x ≤ 0.6) single crystal film and the Group 11 element layer are alternately disposed in the step (d1).

8. A ZnO based compound semiconductor element comprising
an n-type ZnO based compound semiconductor layer,
a ZnO based compound semiconductor active layer formed above the n-type ZnO based compound semiconductor layer,
a first p-type ZnO based compound semiconductor layer formed above the ZnO based compound semiconductor active layer,
a second p-type ZnO based compound semiconductor layer formed above the first p-type ZnO based compound semiconductor layer,
an n electrode electrically connected to the n-type ZnO based compound semiconductor layer, and
a p electrode electrically connected to the second p-type ZnO based compound semiconductor layer, wherein
the second p-type ZnO based compound semiconductor layer is a single crystal layer,
(i) a Group 11 element which is Cu and/or Ag and (ii) at least one Group 13 element selected from the group consisting of B, Ga, Al, and In are co-doped in the second p-type ZnO based compound semiconductor layer,
concentration of the Group 11 element is at least 1 x 10¹⁹ cm⁻³, and the concentration of the Group 11 element is approximately constant in thickness direction of the second p-type ZnO based compound semiconductor layer, and
the first p-type ZnO based compound semiconductor layer is doped with an element which reduces the diffusion of the Group 11 element and the Group 13 element co-doped with the second p-type ZnO based compound semiconductor layer.

9. A ZnO based compound semiconductor element according to claim 8 wherein the element doped in the first p-type ZnO based compound semiconductor layer is at least one element selected from the group consisting of N, P, As, and Sb.

10. A ZnO based compound semiconductor element according to claim 8 wherein the first p-type ZnO based compound semiconductor layer is constituted from a N-doped MgZnO.

11. A ZnO based compound semiconductor element according to claim 8 or 10 wherein the first p-type ZnO based compound semiconductor layer is doped with at least 1.0 x 10¹⁹ cm⁻³ of N.

12. A ZnO based compound semiconductor element according to any one of claims 8 to 11 wherein concentration [11] of the Group 11 element and concentration [13] of the Group 13 element are respectively different in the first p-type ZnO based compound semiconductor layer between the side of the second p-type ZnO based compound semiconductor layer and the side of the ZnO based compound semiconductor active layer by the order of at least 10².

13. A ZnO based compound semiconductor element according to any one of claims 8 to 12 wherein concentration [11] of the Group 11 element and concentration [13] of the Group 13 element in the second p-type ZnO based compound semiconductor layer meet the relation: 1 < [11]/[13] < 100.

14. A ZnO based compound semiconductor element according to claim 13 wherein concentration [11] of the Group 11 element and concentration [13] of the Group 13 element in the second p-type ZnO based compound semiconductor layer meet the relation: 2≤[11]/[13]≤50.
